(19)

Europäisches
Patentamt
European
Patent Office
Office européen
des brevets

(11) **EP 1 767 978 A1**

(12) **EUROPEAN PATENT APPLICATION**
published in accordance with Art. 158(3) EPC

(43) Date of publication:
 **28.03.2007 Bulletin 2007/13**

(51) Int Cl.:
 *G02B 17/08* (2006.01)   *G02B 5/08* (2006.01)
 *G03F 7/20* (2006.01)   *H01L 21/027* (2006.01)

(21) Application number: **05748799.3**

(22) Date of filing: **09.06.2005**

(86) International application number:
 **PCT/JP2005/010589**

(87) International publication number:
 **WO 2005/124420 (29.12.2005 Gazette 2005/52)**

(84) Designated Contracting States:
 **AT BE BG CH CY CZ DE DK EE ES FI FR GB GR HU IE IS IT LI LT LU MC NL PL PT RO SE SI SK TR**

(30) Priority: **16.06.2004 JP 2004178777**
 **17.11.2004 JP 2004332531**

(71) Applicant: **NIKON CORPORATION**
 **Tokyo 100-8331 (JP)**

(72) Inventors:
 • **OMURA, Yasuhiro**
 **c/o NIKON CORPORATION**
 **Tokyo 1008331 (JP)**

• **IIDA, Haruhisa**
 **c/o NIKON CORPORATION**
 **Tokyo 1008331 (JP)**
• **TSUDA, Takeshi**
 **c/o NIKON CORPORATION**
 **Tokyo 1008331 (JP)**

(74) Representative: **Viering, Hans-Martin**
 **Patent- und Rechtsanwälte**
 **Viering, Jentschura & Partner,**
 **Steindorfstrasse 6**
 **80538 München (DE)**

(54) **OPTICAL SYSTEM, EXPOSING APPARATUS AND EXPOSING METHOD**

(57)   An optical system includes a reflecting mirror to which rays are incident across a relatively wide incidence angle range, while well suppressing a change in a polarization state in an optical path of a beam incident substantially as linearly polarized light. The optical system has a first deflecting plane mirror (M11) and a second deflecting plane mirror (M12) and a substantially linearly polarized beam is incident to the optical system. Each of the first deflecting plane mirror and the second deflecting plane mirror is so arranged that a change from a phase difference between p-polarized incident light to a reflecting surface and s-polarized incident light to the reflecting surface, to a phase difference between reflected light of the p-polarized incident light to the reflecting surface and reflected light of the s-polarized incident light to the reflecting surface is within 30° for all rays incident to the reflecting surface.

*Fig.5*

EP 1 767 978 A1

## Description

### Technical Field

The present invention relates to an optical system, exposure apparatus, and exposure method and, more particularly, to a projection optical system suitably applicable to exposure apparatus for fabricating micro devices, such as semiconductor elements, image pickup devices, liquid-crystal display devices, and thin-film magnetic heads, by lithography.

### Background Art

In the typical exposure apparatus of this type, a light beam emitted from a light source is guided through a fly's eye lens as an optical integrator to form a secondary light source as a substantive surface illuminant consisting of a lot of light sources. Beams from the secondary light source are guided through an aperture stop disposed in the vicinity of the rear focal plane of the fly's eye lens, to be limited, and then enter a condenser lens.

The light beams condensed by the condenser lens illuminate a mask with a predetermined pattern therein, in a superposed manner. Light transmitted by the pattern of the mask travels through a projection optical system to be focused on a wafer. In this manner the mask pattern is projected (or transferred) onto the wafer to effect exposure thereof. The pattern formed in the mask is of high integration and a high-contrast pattern image must be formed on the wafer in order to accurately transfer the microscopic pattern onto the wafer.

There is thus the proposed technology of obtaining the high-contrast image of the microscopic pattern on the wafer, for example, by setting a polarization state of exposure light to linear polarization of circumferential vibration (hereinafter referred to as "circumferential polarization state") in the lens aperture (pupil surface) of the projection optical system (cf. Patent Document 1).

Patent Document 1: Japanese Patent Application Laid-Open No. 5-90128

### Disclosure of the Invention

### Problem to be Solved by the Invention

When attention is focused on projection exposure of line patterns arranged in one direction on a mask, diffracted light beams by the line patterns are localized in the pitch direction of the patterns and are distributed along a diameter direction parallel to the pitch direction of the line patterns, in the lens aperture. For this reason, the projection exposure with linearly polarized light having the direction of polarization normal to the pitch direction of the line patterns is substantially optically equivalent to projection exposure in the circumferential (azimuthal) polarization state.

The projection exposure with specific, linearly polarized light as described above is effective to improvement in the resolution of the projection optical system. However, even in the situation where the mask is illuminated with the light in the desired linear polarization state, if an optical element that changes the polarization state of light is interposed in the optical path of the projection optical system, the light will not be focused in the desired linear polarization state and this could result in degradation of imaging performance. Particularly, in the case of a reflector to which rays are incident across a relatively wide incidence angle range, it is known that the reflector is likely to produce relatively large phase shifts due to polarization directions.

An object of the present invention is to provide an optical system including a reflecting mirror to which rays are incident across a relatively wide incidence angle range, while well suppressing a change in a polarization state in an optical path of a light beam incident substantially as linearly polarized light.

Another object of the present invention is to provide an exposure apparatus and exposure method capable of effecting faithful exposure by forming a high-contrast image of a microscopic pattern of a mask on a photosensitive substrate, using an optical system constructed while well suppressing a change in a polarization state in an optical path of a light beam incident substantially as linearly polarized light.

### Means for Solving the Problem

In order to achieve the above objects, a first aspect of the present invention provides an optical system which comprises at least one reflecting mirror and to which a substantially linearly polarized light beam is incident, wherein a maximum incidence angle of rays incident to a reflecting surface of the reflecting mirror is not less than 20°, and wherein the reflecting mirror is so arranged that a change from a phase difference between p-polarized incident light to the reflecting surface and s-polarized incident light to the reflecting surface, to a phase difference between reflected light of the p-polarized incident light to the reflecting surface and reflected light of the s-polarized incident light to the reflecting surface is within 30° for all the rays incident to the reflecting surface.

A second aspect of the present invention provides an exposure apparatus comprising the optical system of the first aspect, and effecting exposure of a pattern on a mask illuminated based on a light beam from a light source, onto a photosensitive substrate.

A third aspect of the present invention provides an exposure method of effecting exposure of a pattern on a mask illuminated based on a light beam from a light source, onto a photosensitive substrate, using the optical system of the first aspect.

**Effect of the Invention**

In the typical aspect of the present invention, for example, a predetermined reflecting surface structure is applied to the reflecting mirror in the projection optical system, whereby the reflecting mirror is so arranged that the change from the phase difference between the p-polarized incident light and the s-polarized incident light to the reflecting surface, to the phase difference between the reflected light of the p-polarized incident light and the reflected light of the s-polarized incident light to the reflecting surface, i.e., p-s phase shift due to polarization directions, is within 30° for all the rays incident to the reflecting surface. As a result, the projection optical system of the present invention is able to well suppress the change in the polarization state in the optical path of the light beam incident substantially as linearly polarized light, while including the reflecting mirror to which the rays are incident across a relatively wide incidence angle range.

Therefore, the exposure apparatus and exposure method of the present invention are able to well suppress the change in the polarization state in the projection optical system, for the light beam incident substantially as linearly polarized light, for example, even in the case of circumferentially polarized annular illumination based on an annular illumination pupil distribution in the circumferential polarization state, to effect faithful exposure by forming a high-contrast image of a microscopic pattern of a mask onto a photosensitive substrate, and to fabricate good devices eventually.

**Brief Description of the Drawings**

Fig. 1 is a drawing schematically showing a configuration of an exposure apparatus according to an embodiment of the present invention.

Fig. 2 is a drawing schematically showing a configuration of a polarization converting element in Fig. 1.

Fig. 3 is a drawing for explaining the optical rotatory power of rock crystal.

Fig. 4 is a drawing schematically showing an annular secondary light source set in a circumferential polarization state by action of the polarization converting element.

Fig. 5 is a drawing schematically showing an internal configuration of a projection optical system according to the embodiment.

Fig. 6 is a drawing schematically showing a configuration of a projection optical system according to a first modification example of the embodiment.

Fig. 7 is a drawing schematically showing a configuration of a projection optical system according to a second modification example of the embodiment.

Fig. 8 is a drawing schematically showing a reflecting surface structure applied to deflecting plane mirrors in the projection optical system in the embodiment.

Fig. 9 is a drawing showing a relation of incidence angle versus phase difference of rays on a deflecting plane mirror to which the reflecting surface structure of Fig. 8 is applied.

Fig. 10 is a drawing schematically showing a reflecting surface structure according to a modification example of the embodiment.

Fig. 11 is a drawing showing a relation of incidence angle versus phase difference of rays on a deflecting plane mirror to which the reflecting surface structure according to the modification example of Fig. 10 is applied.

Fig. 12 is a drawing schematically showing a reflecting surface structure according to another modification example of the embodiment.

Fig. 13 is a drawing showing a relation of incidence angle versus phase difference of rays on a deflecting plane mirror to which the reflecting surface structure according to the modification example of Fig. 12 is applied.

Fig. 14 is a drawing schematically showing a configuration of a liquid immersion type projection optical system corresponding to the projection optical system shown in Fig. 5.

Fig. 15 is a drawing schematically showing configurations between a boundary lens and a wafer in the liquid immersion type projection optical system.

Fig. 16 is a drawing schematically showing a configuration of a liquid immersion type projection optical system corresponding to the projection optical system shown in Fig. 7.

Fig. 17 is a drawing schematically showing an annular secondary light source set in a radial polarization state by action of a polarization converting element.

Fig. 18 is a flowchart of a technique of fabricating semiconductor devices as micro devices.

Fig. 19 is a flowchart of a technique of fabricating a liquid-crystal display element as a micro device.

**Best Mode for Carrying out the Invention**

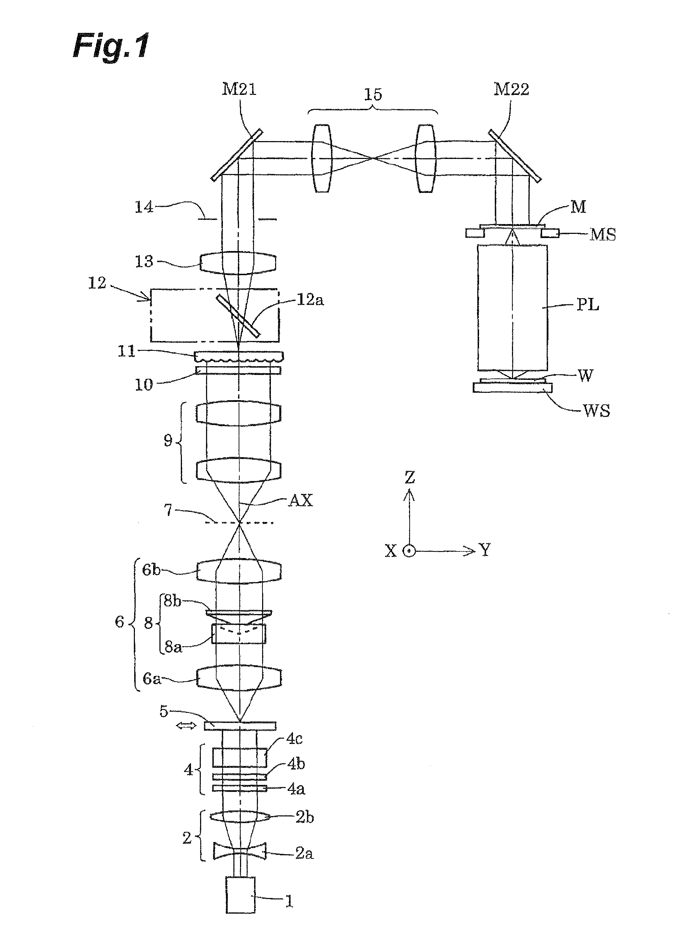

Embodiments of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the Y-axis along a direction parallel to the plane of Fig. 1 in the plane of wafer W, and the X-axis along a direction perpendicular to the plane of Fig. 1 in the plane of wafer W. With reference to Fig. 1, the exposure apparatus of the present embodiment is provided with a light source 1 for supplying exposure light (illumination light).

The light source 1 to be used can be an ArF excimer laser light source for supplying, for example, light of wavelength of 193 nm. A nearly parallel beam emitted along the Z-direction from the light source 1 has a rectangular cross section extending oblongly along the X-direction and is incident to a beam expander 2 consisting of a pair of lenses 2a and 2b. The lenses 2a and 2b have a negative refractive power and a positive refractive power, respectively, in the plane of Fig. 1 (i.e., in the YZ plane). Therefore, the light beam incident to the beam expander 2 is expanded in the plane of Fig. 1 to be shaped into a light beam having a predetermined rectangular cross section.

The nearly parallel beam having passed through the beam expander 2 as a shaping optical system travels via a quarter-wave plate 4a, a half-wave plate 4b, a depolarizer (depolarizing element) 4c, and a diffractive optical element 5 for annular illumination, to enter an afocal lens 6. The quarter-wave plate 4a, half-wave plate 4b, and depolarizer 4c herein constitute a polarization state switch 4, as described later. The afocal lens 6 is an afocal system (afocal optical system) so set that the front focal position thereof is approximately coincident with the position of the diffractive optical element 5 and that the rear focal position thereof is approximately coincident with a position of a predetermined plane 7 indicated by a dashed line in the drawing.

In general, a diffractive optical element is made by forming steps with a pitch approximately equal to the wavelength of the exposure light (illumination light) in a substrate, and functions to diffract an incident beam at desired angles. Specifically, the diffractive optical element 5 for annular illumination has the following function: when a parallel beam of a rectangular cross section is incident to the diffractive optical element 5, it forms a light intensity distribution of an annular shape in its far field (or Fraunhofer diffraction region).

Therefore, the nearly parallel beam incident to the diffractive optical element 5 as a light beam conversion element forms an annular light intensity distribution on the pupil surface of the afocal lens 6 and thereafter emerges in the form of a nearly parallel beam from the afocal lens 6. A conical axicon system 8 is disposed in the optical path between a front lens unit 6a and a rear lens unit 6b of the afocal lens 6 and at or near the pupil surface thereof, and the detailed configuration and action thereof will be described later. For simplification of description, the basic configuration and action will be described below, while ignoring the action of the conical axicon system 8.

The light beam having passed through the afocal lens 6 travels through a zoom lens 9 for variation of σ-value and through a polarization converting element 10 to enter a micro fly's eye lens (or fly's eye lens) 11 as an optical integrator. The configuration and action of the polarization converting element 10 will be described later. The micro fly's eye lens 11 is an optical element consisting of a number of microscopic lenses with a positive refractive power arranged vertically and horizontally and densely. In general, a micro fly's eye lens is made, for example, by forming a microscopic lens group in a plane-parallel plate by etching.

Each of the microscopic lenses constituting the micro fly's eye lens is smaller than each of lens elements constituting a fly's eye lens. The micro fly's eye lens is a lens wherein a number of microscopic lenses (microscopic refracting faces) are integrally formed without being isolated from each other, different from the fly's eye lens consisting of lens elements isolated from each other. However, the micro fly's eye lens is an optical integrator of the same wavefront splitting type as the fly's eye lens in that the lens elements with a positive refractive power are arranged vertically and horizontally.

The predetermined plane 7 is located near the front focal position of the zoom lens 9 and the entrance surface of the micro fly's eye lens 11 is located near the rear focal position of the zoom lens 9. In other words, the zoom lens 9 functions to arrange the predetermined plane 7 and the entrance surface of the micro fly's eye lens 11 substantially in the relation of Fourier transform and, eventually, to arrange the pupil surface of the afocal lens 6 and the entrance surface of the micro fly's eye lens 11 substantially optically conjugate with each other.

Therefore, for example, an annular illumination field is formed around the optical axis AX on the entrance surface of the micro fly's eye lens 11, as on the pupil surface of the afocal lens 6. The overall shape of this annular illumination field varies similarly depending upon the focal length of the zoom lens 9. Each microscopic lens forming the micro fly's eye lens 11 has a rectangular cross section similar to a shape of an illumination field to be formed on a mask M (and, eventually, similar to a shape of an exposure region to be formed on a wafer W).

The light beam incident to the micro fly's eye lens 11 is two-dimensionally split by the multiple microscopic lenses to form a secondary light source having much the same light intensity distribution as the illumination field formed by the incident beam, i.e., a secondary light source consisting of a substantive surface illuminant of an annular shape around the optical axis AX, on or near the rear focal plane of the micro fly's eye lens 11 (and on the illumination pupil eventually). Beams from the secondary light source formed on or near the rear focal plane of the micro fly's eye lens 11 travel through a beam splitter 12a and a condenser optical system 13 and then illuminate a mask blind 14 in a superposed manner.

In this manner, a rectangular illumination field according to the shape and focal length of each microscopic lens forming the micro fly's eye lens 11 is formed on the mask blind 14 as an illumination field stop. A light beam having passed through a rectangular aperture (light transmitting portion) of the mask blind 14 is deflected into the Y-direction by a deflecting plane mirror (plane reflector) M21 for folding of the optical path and is then incident to an imaging optical system 15. The light beam subject to focusing action of the imaging optical system 15 is then deflected into the Z-direction by a deflecting plane mirror M22 for folding of the optical path and then illuminates the mask M with a predetermined pattern therein, in a superposed manner.

Namely, the imaging optical system 15 forms an image of the rectangular aperture of the mask blind 14 on the mask M. A light beam transmitted by the pattern of the mask M held on a mask stage MS travels through a projection optical system PL to form an image of the mask pattern on a wafer (photosensitive substrate) W held on a wafer stage WS. The internal configuration of the projection optical system PL will be described later. While the wafer W is two-dimensionally driven and controlled in the plane (XY plane) perpendicular to the optical axis AX of the projection optical system PL, one-shot exposure or scan exposure is effected to sequentially project the pattern of the mask M into each of exposure regions on the wafer W.

In the polarization state switch 4, the quarter-wave plate 4a is arranged so that the crystallographic axis thereof is rotatable around the optical axis AX, and converts incident light of elliptic polarization into light of linear polarization. The half-wave plate 4b is arranged so that the crystallographic axis thereof is rotatable around the optical axis AX, and changes the plane of polarization of incident linearly polarized light. The depolarizer 4c is composed of a rock crystal prism of wedge shape and a silica glass prism of wedge shape having complementary shapes. The rock crystal prism and the silica glass prism are constructed as an integral prism assembly so as to be freely inserted into or retracted from the illumination optical path.

When the light source 1 is a KrF excimer laser light source or an ArF excimer laser light source, light emitted from these light sources typically has the degree of polarization of not less than 95% and nearly linearly polarized light is incident to the quarter-wave plate 4a. However, if a right-angle prism is interposed as a back reflector in the optical path between the light source 1 and the polarization state switch 4, total reflection in the right-angle prism will convert linear polarization into elliptic polarization unless the plane of polarization of the incident linearly polarized light coincides with the p-polarization plane or s-polarization plane.

In the polarization state switch 4, for example, even if light of elliptic polarization is incident because of the total reflection in the right-angle prism, it will be converted into light of linear polarization by the action of the quarter-wave plate 4a and the linearly polarized light will be incident to the half-wave plate 4b. When the crystallographic axis of the half-wave plate 4b is set at an angle of 0° or 90° relative to the plane of polarization of incident linearly polarized light, the light of linear polarization incident to the half-wave plate 4b passes directly without change in the plane of polarization.

When the crystallographic axis of the half-wave plate 4b is set at an angle of 45° relative to the plane of polarization of incident linearly polarized light, the light of linear polarization incident to the half-wave plate 4b is converted into light of linear polarization with the plane of polarization changed by 90°. Furthermore, when the crystallographic axis of the rock crystal prism of the depolarizer 4c is set at an angle of 45° relative to the plane of polarization of incident linearly polarized light, the light of linear polarization incident to the rock crystal prism is converted (or depolarized) into light in an unpolarized state.

The polarization state switch 4 is so arranged that the crystallographic axis of the rock crystal prism makes the angle of 45° relative to the plane of polarization of incident linearly polarized light when the depolarizer 4c is positioned in the illumination optical path. In passing, if the crystallographic axis of the rock crystal prism is set at an angle of 0° or 90° relative to the plane of polarization of incident linearly polarized light, the light of linear polarization incident to the rock crystal prism will pass directly without change in the plane of polarization. When the crystallographic axis of the half-wave plate 4b is set at an angle of 22.5° relative to the plane of polarization of incident linearly polarized light, the light of linear polarization incident to the half-wave plate 4b is converted into light in an unpolarized state including a linear polarization component passing directly without change in the plane of polarization, and a linear polarization component with the plane of polarization changed by 90°.

In the polarization state switch 4, as described above, the light of linear polarization is incident to the half-wave plate 4b, and let us assume herein that light of linear polarization with the polarization direction (the direction of the electric field) along the Y-direction in Fig. 1 (which will be referred to hereinafter as "Y-directional polarization") is incident to the half-wave plate 4b, for simplification of the description hereinafter. When the depolarizer 4c is positioned in the illumination optical path and when the crystallographic axis of the half-wave plate 4b is set at the angle of 0° or 90° relative to the plane of polarization (direction of polarization) of incident Y-directionally polarized light, the light of Y-directional polarization incident to the half-wave plate 4b passes as Y-directionally polarized light without change in the plane of polarization and then is incident to the rock crystal prism of the depolarizer 4c. Since the crystallographic axis of the rock crystal prism is set at the angle of 45° relative to the plane of polarization of the incident Y-directionally polarized light, the light of Y-directional polarization incident to the rock crystal prism is converted into light in an unpolarized state.

The light depolarized through the rock crystal prism travels through the silica glass prism as a compensator for compensating the traveling direction of light, and is then incident in an unpolarized state into the diffractive optical element 5. On the other hand, when the crystallographic axis of the half-wave plate 4b is set at the angle of 45° relative to the plane of polarization of the incident Y-directionally polarized light, the light of Y-directional polarization incident to the half-wave plate 4b is converted into light with the plane of polarization changed by 90°, i.e., light of linear polarization having the direction of polarization (direction of the electric field) along the X-direction in Fig. 1 (which will be referred to hereinafter as "X-directional polarization") to enter the rock crystal prism of the depolarizer 4c. Since the crystallographic axis of the rock crystal prism is also set at the angle of 45° relative to the plane of polarization of the incident X-directionally polarized light, the light of the X-directional polarization incident to the rock crystal prism is converted into light in an unpolarized state to travel through the silica glass prism and then to be incident in an unpolarized state to the diffractive optical element 5.

In contrast to it, when the depolarizer 4c is retracted from the illumination optical path and when the crystallographic axis of the half-wave plate 4b is set at the angle of 0° or 90° relative to the plane of polarization of the incident Y-directionally polarized light, the light of Y-directional polarization incident to the half-wave plate 4b passes as Y-directionally polarized light without change in the plane of polarization, and is incident in a Y-directional polarization state to the diffractive optical element 5. On the other hand, when the crystallographic axis of the half-wave plate 4b is set at the angle of 45° relative to the plane of polarization of the incident Y-directionally polarized light, the light of Y-directional polarization incident to the half-wave plate 4b is converted into light of X-directional polarization with the plane of polarization changed by 90°, and is incident in an X-directional polarization state to the diffractive optical element 5.

As described above, the polarization state switch 4 is able to make the light in the unpolarized state incident to the diffractive optical element 5 when the depolarizer 4c is inserted and positioned in the illumination optical path. It is also able to make the light in the Y-directional polarization state incident to the diffractive optical element 5 when the depolarizer 4c is retracted from the illumination optical path and when the crystallographic axis of the half-wave plate 4b is set at the angle of 0° or 90° relative to the plane of polarization of the incident Y-directionally polarized light. Furthermore, it is also able to make the light in the X-directional polarization state incident to the diffractive optical element 5 when the depolarizer 4c is retracted from the illumination optical path and when the crystallographic axis of the half-wave plate 4b is set at the angle of 45° relative to the plane of polarization of the incident Y-directionally polarized light.

In other words, the polarization state switch 4 is able to switch the polarization state of light incident to the diffractive optical element 5 (consequently, the polarization state of light to illuminate the mask M and wafer W) between a linear polarization state and the unpolarized state and, in the case of the linear polarization state, it is able to switch the polarization of incident light between polarization states orthogonal to each other (i.e., between the Y-directional polarization and the X-directional polarization), through the action of the polarization state switch consisting of the quarter-wave plate 4a, the half-wave plate 4b, and the depolarizer 4c.

Next, the conical axicon system 8 is composed of a first prism member 8a a plane (flat surface) of which faces the light source side and a refracting surface of a concave conical shape of which faces the mask side, and a second prism member 8b a plane (flat surface) of which faces the mask side and a refracting surface of a convex conical shape of which faces the light source side, in order from the light source side. Then the refracting surface of the concave conical shape of the first prism member 8a and the refracting surface of the convex conical shape of the second prism member 8b are formed in such complementary shapes as to be able to butt each other. At least one of the first prism member 8a and the second prism member 8b is arranged to be movable along the optical axis AX to vary the distance between the refracting surface of the concave conical shape of the first prism member 8a and the refracting surface of the convex conical shape of the second prism member 8b.

In a state in which the refracting surface of the concave conical shape of the first prism member 8a butts against the refracting surface of the convex conical shape of the second prism member 8b, the conical axicon system 8 functions as a plane-parallel plate and has no effect on the secondary light source of annular shape formed. However, when the refracting surface of the concave conical shape of the first prism member 8a is located apart from the refracting surface of the convex conical shape of the second prism member 8b, the outside diameter (inside diameter) of the annular secondary light source varies while the width of the annular secondary light source (half of the difference between the outside diameter and the inside diameter of the annular secondary light source) is kept constant. Namely, an annular ratio (inside diameter/outside diameter) and the size (outside diameter) of the annular secondary light source change.

The zoom lens 9 has a function of similarly enlarging or reducing the overall shape of the annular secondary light source. For example, when the focal length of the zoom lens 9 is increased from a minimum to a predetermined value, the overall shape of the annular secondary light source is similarly enlarged. In other words, the width and size (outside diameter) of the annular secondary light source vary without change in the annular ratio thereof, through the action of the zoom lens 9. In this manner, the annular ratio and size (outside diameter) of the annular secondary light source can be controlled by the action of the conical axicon system 8 and the zoom lens 9.

A polarization monitor 12 is provided with a first beam splitter 12a disposed in the optical path between the micro fly's eye lens 11 and the condenser optical system 13, and has a function of detecting a polarization state of incident light to this first beam splitter 12a. When a controller confirms that the illumination light to the mask M (and to the wafer W eventually) is not in a desired polarization state or in an unpolarized state on the basis of the detection result by the polarization monitor 12, it drives and adjusts the quarter-wave plate 4a, half-wave plate 4b, and depolarizer 4c constituting the polarization state switch 4, to adjust the state of the illumination light to the mask M into the desired polarization state or into the unpolarized state.

When a diffractive optical element for quadrupole illumination (not shown) is set in the illumination optical path, instead of the diffractive optical element 5 for annular illumination, it can effect quadrupole illumination. The diffractive optical element for quadrupole illumination has the following function: when a parallel beam having a rectangular cross section is incident thereto, it forms a light intensity distribution of quadrupole shape in its far field. Therefore, beams having passed through the diffractive optical element for quadrupole illumination form an illumination field of quadrupole shape consisting of four circular illumination fields around the optical axis AX, for example, on the entrance surface of the micro fly's eye lens 11. As a result, a secondary light source of the same quadrupole shape as the illumination field formed on the entrance surface is also formed on the rear focal plane of the micro fly's eye lens 11.

When a diffractive optical element for circular illumination (not shown) is set in the illumination optical path, instead of the diffractive optical element 5 for annular illumination, it can effect normal circular illumination. The diffractive optical element for circular illumination has the following function: when a parallel beam having a rectangular cross section is incident thereto, it forms a light intensity distribution of circular shape in its far field. Therefore, a light beam having passed through the diffractive optical element for circular illumination forms an illumination field of quadrupole shape consisting of a circular illumination field around the optical axis AX, for example, on the entrance surface of the micro fly's eye lens 11. As a result, the secondary light source of the same circular shape as the illumination field formed on the entrance surface is also formed on or near the rear focal plane of the micro fly's eye lens 11.

Furthermore, when another diffractive optical element for multi-pole illumination (not shown) is set in the illumination optical path, instead of the diffractive optical element 5 for annular illumination, it is feasible to implement one of various multi-pole illuminations (dipole illumination, octupole illumination, etc.). Similarly, when a diffractive optical element with an appropriate characteristic (not shown) is set in the illumination optical path, instead of the diffractive optical element 5 for annular illumination, it becomes feasible to implement one of off-axis or modified illuminations of various forms.

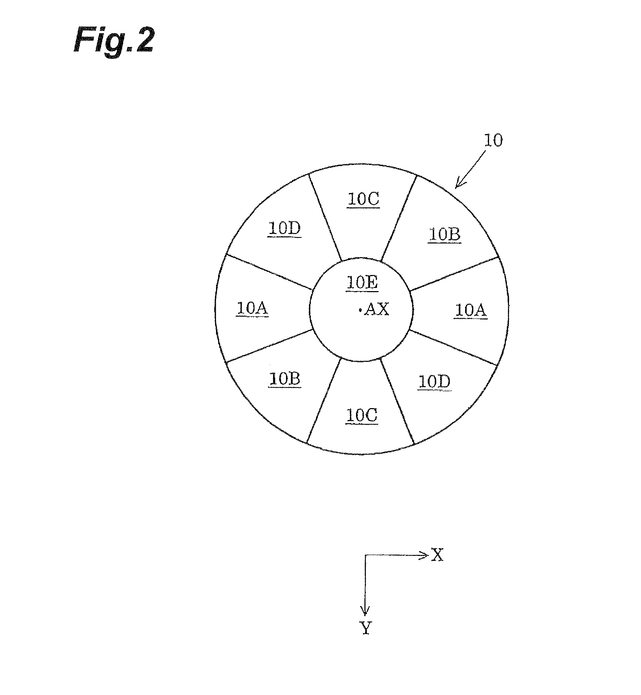

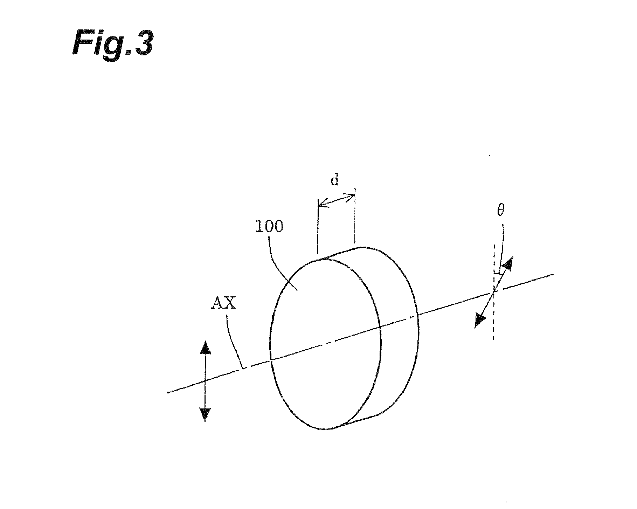

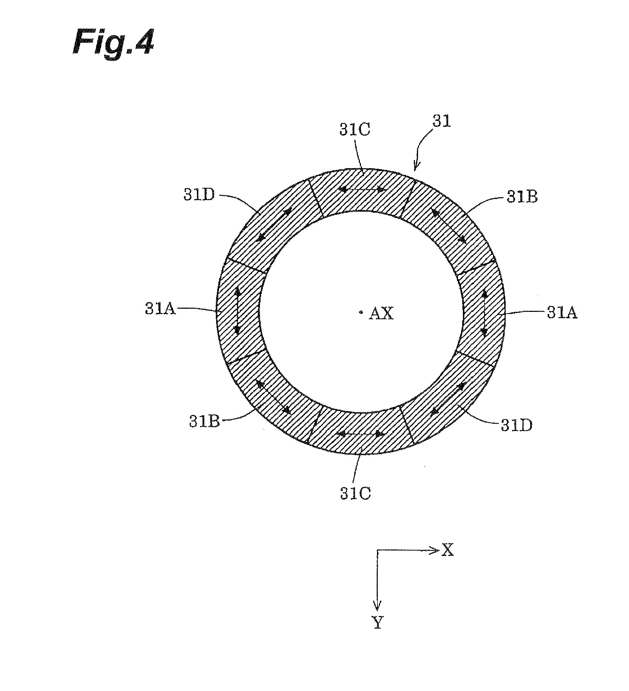

Fig. 2 is a drawing schematically showing the configuration of the polarization converting element shown in Fig. 1. Fig. 3 is a drawing for explaining the optical rotatory power of rock crystal. Fig. 4 is a drawing schematically showing an annular secondary light source set in the circumferential polarization state by the action of the polarization converting element. The polarization converting element 10 according to the present embodiment is located immediately before the micro fly's eye lens 11, i.e., on or near the illumination pupil. Therefore, in the case of annular illumination, a light beam having an approximately annular cross section around the optical axis AX is incident to the polarization converting element 10.

With reference to Fig. 2, the polarization converting element 10 has an annular effective region around the optical axis AX as a whole, and is composed of eight sector basic elements equally divided in the circumferential direction around the optical axis AX. Among these eight basic elements, a pair of basic elements facing each other on both sides of the optical axis AX have characteristics equal to each other. Namely, the eight basic elements include four types of basic elements 10A-10D having mutually different thicknesses along the direction of transmission of light (Z-direction) (i.e., lengths in the optical-axis direction).

Specifically, the thicknesses are set as follows: the thickness of the first basic element 10A is the largest, the thickness of the fourth basic element 10D the smallest, and the thickness of the second basic element 10B is larger than the thickness of the third basic element 10C. As a result, one surface (e.g., entrance surface) of the polarization converting element 10 is planar, while the other surface (e.g., exit surface) is uneven because of the differences among the thicknesses of the respective basic elements 10A-10D. It is also possible to form the both surfaces of the polarization converting element 10 (the entrance surface and exit surface) in uneven shape.

In the present embodiment, each basic element 10A-10D is made of rock crystal being an optical material with optical rotatory power, and the crystallographic axis of each basic element 10A-10D is set to be approximately coincident with the optical axis AX. The optical rotatory power of rock crystal will be briefly described below with reference to Fig. 3. With reference to Fig. 3, an optical member 100 of a plane-parallel plate shape made of rock crystal and having a thickness d is arranged so that its crystallographic axis coincides with the optical axis AX. In this case, the direction of polarization of incident linearly polarized light is rotated by θ around the optical axis AX by the optical rotatory power of the optical member 100 and the light is outputted in the θ-rotated state.

At this time, a rotation angle (angle of rotation) θ of the polarization direction by the optical rotatory power of the optical member 100 is expressed by Eq (1) below, using the thickness d of the optical member 100 and the optical rotatory power ρ of rock crystal.

$$\theta = d \cdot \rho \qquad (1)$$

In general, the optical rotatory power ρ of rock crystal has wavelength dependence (a property in which the value of optical rotatory power differs depending upon the wavelength of used light: optically rotating dispersion) and, specifically, it tends to increase with decrease in the wavelength of used light. According to the description on p167 in "Applied Optics II," the optical rotatory power ρ of rock crystal for light with the wavelength of 230.3 nm is 153.9°/mm.

In the present embodiment, the first basic element 10A has the thickness dA set as follows: when linearly polarized light having the polarization direction along the Y-direction is incident thereto, it outputs linearly polarized light having the polarization direction along a direction resulting from +180° rotation of the Y-direction around the Z-axis, i.e., along the Y-direction. In this case, therefore, the Y-direction is a direction of polarization of beams passing through a pair of arcuate regions 31A formed by beams subject to the optically rotating action of the pair of first basic elements 10A, in the annular secondary light source 31 shown in Fig. 4.

The second basic element 10B has the thickness dB set as follows: when linearly polarized light having the polarization direction along the Y-direction is incident thereto, it outputs linearly polarized light having the polarization direction along a direction resulting from +135° rotation of the Y-direction around the Z-axis, i.e., along a direction resulting from -45° rotation of the Y-direction around the Z-axis. In this case, therefore, the direction resulting from -45° rotation of the Y-direction around the Z-axis is the polarization direction of beams passing through a pair of arcuate regions 31B formed by beams subject to the optically rotating action of the pair of second basic elements 10B, in the annular secondary light source 31 shown in Fig. 4.

The third basic element 10C has the thickness dC set as follows: when linearly polarized light having the polarization direction along the Y-direction is incident thereto, it outputs linearly polarized light having the polarization direction along a direction resulting from +90° rotation of the Y-direction around the Z-axis, i.e., along the X-direction. In this case, therefore, the X-direction is the polarization direction of beams passing through a pair of arcuate regions 31C formed by beams subject to the optically rotating action of the pair of third basic elements 10C, in the annular secondary light source 31 shown in Fig. 4.

The fourth basic element 10D has the thickness dD set as follows: when linearly polarized light having the polarization direction along the Y-direction is incident thereto, it outputs linearly polarized light having the polarization direction along a direction resulting from +45° rotation of the Y-direction around the Z-axis. In this case, therefore, the direction resulting from +45° rotation of the Y-direction around the Z-axis is the polarization direction of beams passing through a pair of arcuate regions 31D formed by beams subject to the optically rotating action of the pair of fourth basic elements 10D, in the annular secondary light source 31 shown in Fig. 4.

The polarization converting element 10 can be fabricated by combining the eight basic elements formed separately, or the polarization converting element 10 can also be fabricated by forming the required uneven shape (steps) in a rock crystal substrate of a plane-parallel plate shape. In order to implement normal circular illumination without retracting the polarization converting element 10 from the optical path, there is provided a circular center region 10E having a size not less than one third of the radial size of the effective region of the polarization converting element 10 and having no optical rotatory power. The center region 10E herein may be made of an optical material without optical rotatory power, e.g., like quartz, or may be simply a circular aperture. It is, however, noted that the center region 10E is not an essential element for the polarization converting element 10.

In the present embodiment, circumferential polarization annular illumination (off-axis illumination in which beams passing through the annular secondary light source are set in the circumferential polarization state) is implemented as follows: the depolarizer 4c of the polarization state switch 4 is retracted from the illumination optical path, and the angular position of the crystallographic axis of the half-wave plate 4b is so adjusted around the optical axis as to make Y-directionally polarized light incident to the diffractive optical element 5 for annular illumination, whereby linearly polarized light having the polarization direction along the Y-direction is made incident to the polarization converting element 10. As a result, as shown in Fig. 4, the annular secondary light source (annular illumination pupil distribution) 31 is formed on or near the rear focal plane of the micro fly's eye lens 11, and beams passing through this annular secondary light source 31 are set in the circumferential polarization state. In the circumferential polarization state, beams passing through the respective arcuate regions 31A-31I7 constituting the annular secondary light source 31 are in a linear polarization state with the polarization direction approximately coincident with a direction of a tangent to a circle centered around the optical axis AX, at the center position along the circumferential direction of each arcuate region 31A-31D.

In this manner, the present embodiment is able to form the annular secondary light source 31 in the circumferential polarization state, without substantive occurrence of loss in quantity of light, by the optically rotating action of the polarization converting element 10. In other words, the illumination optical apparatus of the present embodiment is able to form the annular illumination pupil distribution in the circumferential polarization state, while well suppressing loss in quantity of light. In the circumferential polarization annular illumination based on the annular illumination pupil distribution in the circumferential polarization state, light projected onto the wafer W as a final surface to be illuminated is in a polarization state in which the principal component is s-polarized light.

The s-polarized light is defined as linearly polarized light having the polarization direction along a direction normal to the plane of incidence (i.e., polarized light whose electric vector vibrates in the direction normal to the plane of incidence). The plane of incidence is a plane defined as follows: when a ray reaches a boundary to a medium (surface to be illuminated: surface of wafer W), the plane of incidence is a plane including a normal to the boundary at the reaching point and a direction of incidence of the ray. As a result, the circumferential polarization annular illumination improves the optical performance (depth of focus or the like) of the projection optical system and provides a high-contrast image of the mask pattern on the wafer (photosensitive substrate).

In general, without being limited to the annular illumination, it is also possible to realize a situation wherein the light incident to the wafer W is in the polarization state in which the principal component is s-polarized light, and wherein a high-contrast image of the mask pattern is obtained on the wafer W, for example, by illumination based on a multi-pole illumination pupil distribution in the circumferential polarization state. In this case, a diffractive optical element for multi-pole illumination (dipole illumination, quadrupole illumination, octupole illumination, etc.) is set in the illumination optical path, instead of the diffractive optical element 5 for annular illumination, the depolarizer 4c is retracted from the illumination optical path, and the angular position of the crystallographic axis of the half-wave plate 4b is so adjusted around the optical axis as to make Y-directionally polarized light incident to the diffractive optical element for multi-pole illumination, whereby linearly polarized light having the polarization direction along the Y-direction is made incident to the polarization converting element 10. Furthermore, when the mask M is illuminated with linearly polarized light having the polarization direction perpendicular to the pitch direction of line patterns on the mask M, as described previously, the light incident to the wafer W is also in the polarization state in which the principal component is s-polarized light, and a high-contrast image of the mask pattern can be obtained on the wafer W.

However, even if the mask M is illuminated with light in the desired linear polarization state and if an optical element that changes the polarization state of light is interposed in the optical path of the projection optical system PL, as described previously, the light will fail to be focused in the desired linear polarization state (the polarization state in which the principal component is s-polarized light) on the wafer W and this could degrade the imaging performance. It is known in particular that there occur relatively large phase shifts due to polarization directions with a reflecting mirror, particularly, with a deflecting plane mirror for folding of the optical path across a wide incidence angle range. On the other hand, to adopt a catadioptric optical system including a deflecting plane mirror, is effective for securing a large image-side numerical aperture NA in the projection optical system PL and thus for securing a high resolving power thereof.

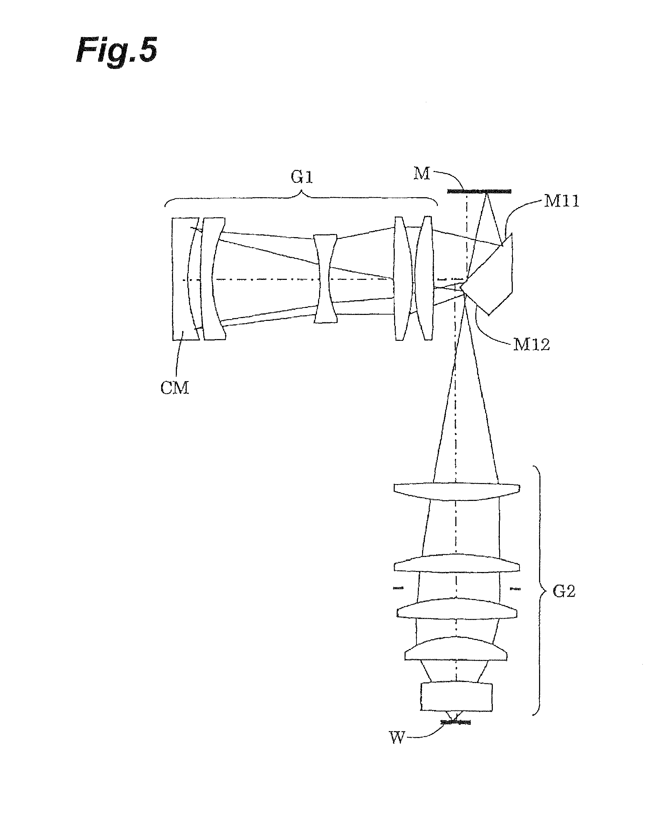

Fig. 5 is a drawing schematically showing the internal configuration of the projection optical system according to the present embodiment. With reference to Fig. 5, the projection optical system PL of the present embodiment is provided with a catadioptric first imaging optical system G1 for forming an intermediate image of the pattern of the mask M. The first imaging optical system G1 has a concave reflecting mirror CM, a plurality of lenses, and a first deflecting plane mirror M11, and forms the intermediate image on the basis of the light beam from the mask M. A second deflecting plane mirror M12 is located near the position where the intermediate image is formed by the first imaging optical system G1.

The second deflecting plane mirror M12 deflects the light beam to the intermediate image or the light beam from the intermediate image toward a refracting second imaging optical system G2. The second imaging optical system G2 forms a final image of the pattern of the mask M on the wafer W, based on the light beam from the intermediate image. The first deflecting plane mirror M11 and the second deflecting plane mirror M12 both have their respective planar reflecting surfaces and are integrally constructed as a single optical member (one folding mirror) having the two reflecting surfaces.

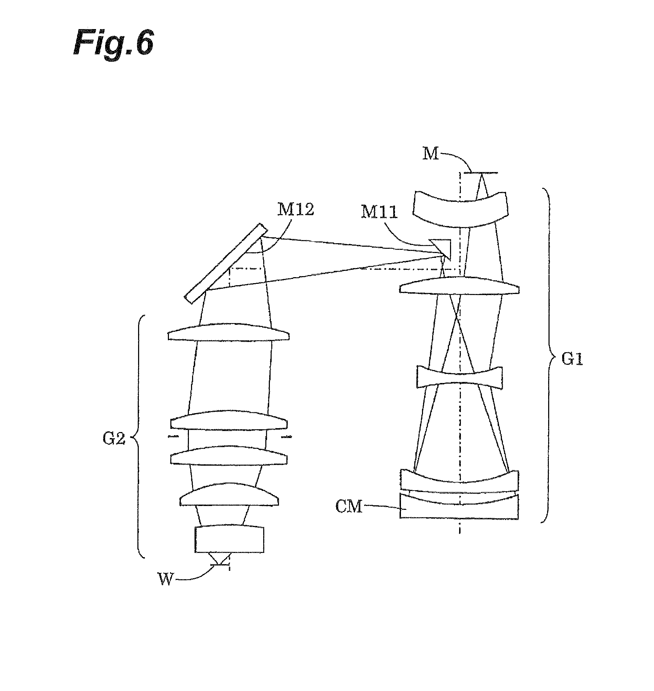

Fig. 6 is a drawing schematically showing a configuration of a projection optical system according to a first modification example of the present embodiment. With reference to Fig. 6, the projection optical system PL of the first modification example is provided with a catadioptric first imaging optical system G1 for forming an intermediate image of the pattern of the mask M. The first imaging optical system G1 has a concave reflecting mirror CM and a plurality of lenses, and forms the intermediate image on the basis of the light beam from the mask M. A first deflecting plane mirror M11 is disposed near the formation position of the intermediate image formed by the first imaging optical system G1.

The first deflecting plane mirror M11 deflects the light beam from the intermediate image toward a second deflecting plane mirror M12. Furthermore, the second deflecting plane mirror M12 deflects the light beam from the intermediate image toward a refracting second imaging optical system G2. The second imaging optical system G2 forms a final image of the pattern of the mask M on the wafer W, based on the light beam from the intermediate image. The first imaging optical system G1 and the second imaging optical system G2 both have their respective optical axes extending linearly, and these two optical axes are set approximately in parallel with each other.

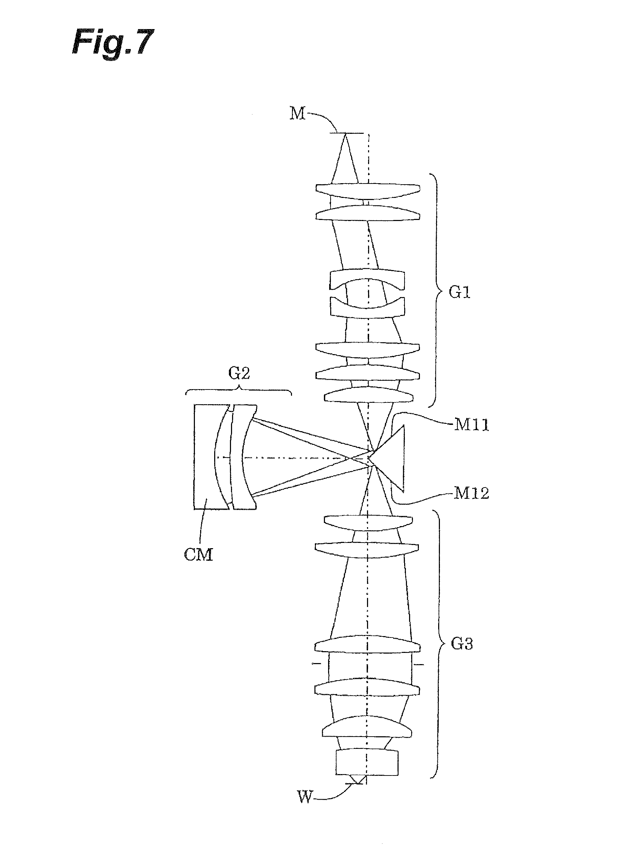

Fig. 7 is a drawing schematically showing a configuration of a projection optical system according to a second modification example of the present embodiment. With reference to Fig. 7, the projection optical system PL of the second modification example is provided with a refracting first imaging optical system G1 for forming a first intermediate image of the pattern of the mask M. A first deflecting plane mirror M11 is located near the formation position of the first intermediate image formed by the first imaging optical system G1 (a position optically conjugate with the first surface (second surface)). The first deflecting plane mirror M11 deflects the light beam to the first intermediate image or the light beam from the first intermediate image toward a catadioptric second imaging optical system G2.

The second imaging optical system G2 has a concave reflecting mirror CM and a lens, and forms a second intermediate image (an image of the first intermediate image and secondary image of the pattern) near the formation position of the first intermediate image on the basis of the light beam from the first intermediate image. A second deflecting plane mirror M12 is located near the formation position of the second intermediate image formed by the second imaging optical system G2 (a position optically conjugate with the first surface (second surface)). The second deflecting plane mirror M12 deflects the light beam to the second intermediate image or the light beam from the second intermediate image toward a refracting third imaging optical system G3.

The third imaging optical system G3 forms a reduced image of the pattern of the mask M (an image of the second intermediate image and final image by the projection optical system) on the wafer W, based on the light beam from the second intermediate image. In this configuration, the reflecting surface of the first deflecting plane mirror M11 and the reflecting surface of the second deflecting plane mirror M12 are positioned so as not to spatially interfere with each other. The first deflecting plane mirror M11 and the second deflecting plane mirror M12 both have their respective planar reflecting surfaces and are integrally constructed as a single optical member (one folding mirror) having the two reflecting surfaces. The positions optically conjugate with the first surface (second surface) lie on the path of the first deflecting plane mirror M11 on the concave reflecting mirror CM side and on the optical path of the second deflecting plane mirror M12 on the concave reflecting mirror CM side.

The projection optical systems PL according to the aforementioned embodiment and respective modification examples have one concave reflecting mirror CM, and two deflecting plane mirrors M11 and M12 for folding of the optical path. The concave reflecting mirror CM is located on or near the pupil of the projection optical system PL and the concave reflecting mirror CM is unlikely to cause phase shifts due to polarization directions because the incidence angle range of rays incident to the concave reflecting mirror CM is relatively small. In contrast to it, the pair of deflecting plane mirrors M11 and M12 are likely to cause relatively large phase shifts due to polarization directions because the incidence angle range is wide (e.g., the maximum incidence angle is 20° or more).

If the polarization state of light is subjected to relatively large change in the optical path of the projection optical system PL because of the phase shifts due to polarization directions on the first deflecting plane mirror M11 and on the second deflecting plane mirror M12, the light will fail to be focused in the desired linear polarization state (the polarization state in which the principal component is s-polarized light) on the wafer W and this could degrade the imaging performance. In the present embodiment, therefore, a reflecting surface structure capable of well suppressing occurrence of phase shifts due to polarization directions even with incidence of rays across a relatively wide incidence angle range is applied to the first deflecting plane mirror M11 and the second deflecting plane mirror M12 in the projection optical system PL.

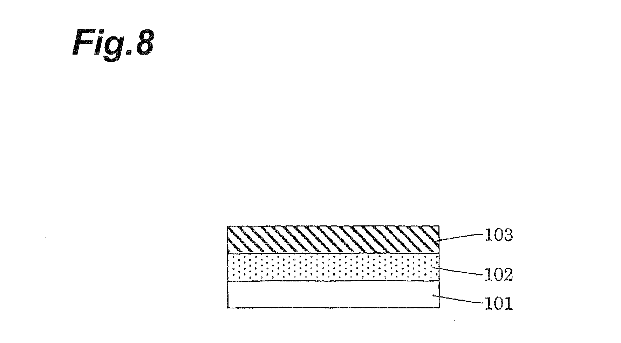

Fig. 8 is a drawing schematically showing a reflecting surface structure applied to the deflecting plane mirrors in the projection optical system in the present embodiment. With reference to Fig. 8, the reflecting surface structure of the present embodiment applied to the first deflecting plane mirror M1 and the second deflecting plane mirror M12 in the projection optical system PL is comprised of a glass substrate 101 optically polished, an aluminum (Al) film 102 as a metal layer formed on the glass substrate 101 as a base material, and a magnesium fluoride ($MgF_2$) film 103 as a dielectric layer formed on the aluminum film 102.

The aluminum film 102 has the film thickness of 100-150 nm, the refractive index of 0.172, and the absorption coefficient of 2.22. The magnesium fluoride film 103 has the optical thickness of $0.25\lambda$, where $\lambda$ is a designed principal wavelength (the wavelength of ArF excimer laser light in the present embodiment: 193 nm), and the refractive index of 1.41. In the present embodiment, the aluminum film 102 and the magnesium fluoride film 103 are formed by vacuum evaporation, but, without having to be limited to this method, it is also possible to use various sputtering methods and ion processing methods (ion assist, ion plating, and ion beam sputtering).

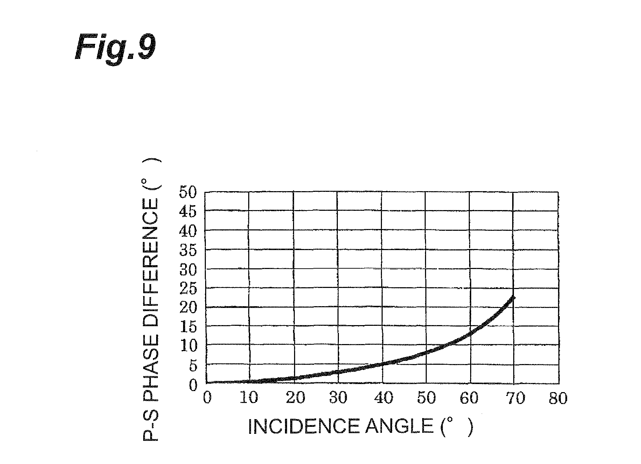

Fig. 9 is a drawing showing a relation of incidence angle versus phase difference of rays on a deflecting plane mirror to which the reflecting surface structure of Fig. 8 is applied. In Fig. 9, the horizontal axis represents incidence angles (°) of rays to the reflecting surface. On the other hand, the vertical axis represents absolute values (°) of changes from a phase difference between p-polarized incident light and s-polarized incident light to the reflecting surface, to a phase difference between reflected light of the p-polarized incident light and reflected light of the s-polarized incident light to the reflecting surface (i.e., p-s phase shifts due to polarization directions). With reference to Fig. 9, it is seen that the p-s phase shifts due to polarization directions are controlled to below about 23° across a wide incidence angle range of 0° to about 70°.

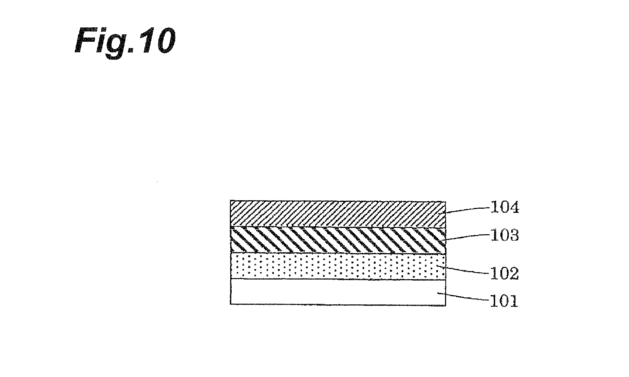

Fig. 10 is a drawing schematically showing a reflecting surface structure according to a modification example of the present embodiment. With reference to Fig. 10, the reflecting surface structure according to the modification example of the present embodiment is composed of a glass substrate 101 optically polished, an aluminum (A1) film 102 as a metal layer formed on the glass substrate 101 as a base material, a magnesium fluoride ($MgF_2$) film 103 as a first dielectric layer formed on the aluminum film 102, and a lanthanum fluoride ($LaF_3$) film 104 as a second dielectric layer formed on the magnesium fluoride film 103.

The aluminum film 102 has the film thickness of 100-150 nm, the refractive index of 0.172, and the absorption coefficient of 2.22. The magnesium fluoride film 103 has the optical thickness of 0.25λ, where λ is the designed principal wavelength, and the refractive index of 1.41. The lanthanum fluoride film 104 has the optical thickness of 0.22λ, where λ is the designed principal wavelength, and the refractive index of 1.65. In the modification example of Fig. 10, the aluminum film 102, magnesium fluoride film 103, and lanthanum fluoride film 104 can also be formed by vacuum evaporation or the like.

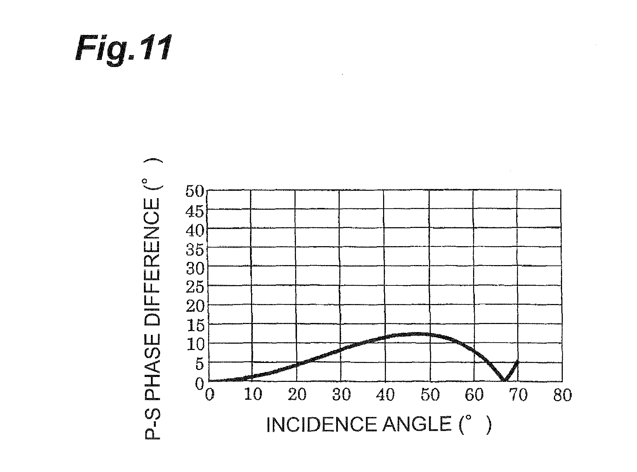

Fig. 11 is a drawing showing a relation of incidence angle versus phase difference of rays on a deflecting plane mirror to which the reflecting surface structure according to the modification example of Fig. 10 is applied. In Fig. 11, similar to Fig. 9, the horizontal axis represents incidence angles (°) and the vertical axis absolute values (°) of p-s phase shifts due to polarization directions. With reference to Fig. 11, it is seen that p-s phase shifts due to polarization directions are controlled to below about 13° across a wide incidence angle range of 0° to about 70°.

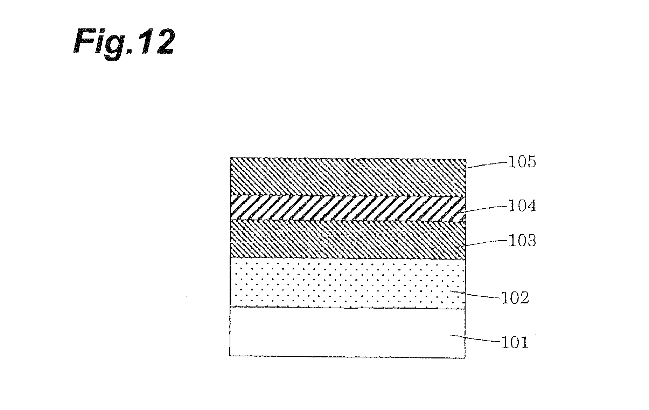

Fig. 12 is a drawing schematically showing a reflecting surface structure according to another modification example of the present embodiment. The reflecting surface structure according to the modification example of Fig. 12 is composed of a glass substrate 101 optically polished, an aluminum (Al) film 102 as a metal layer formed on the glass substrate 101 as a base material, a magnesium fluoride ($MgF_2$) film 103 as a first dielectric layer formed on the aluminum film 102, a lanthanum fluoride ($LaF_3$) film 104 as a second dielectric layer formed on the magnesium fluoride film 103, and a magnesium fluoride film 105 as a third dielectric layer formed on the lanthanum fluoride film 104.

The aluminum film 102 has the film thickness of 150 nm, the refractive index of 0.17247, and the absorption coefficient of 2.22527. The magnesium fluoride film 103 has the film thickness of 44.21 nm and the refractive index of 1.43271. The lanthanum fluoride film 104 has the film thickness of 16.79 nm and the refractive index of 1.63189. The magnesium fluoride film 105 has the film thickness of 61.2 nm and the refractive index of 1.43271. In the modification example of Fig. 12, the aluminum film 102, magnesium fluoride film 103, lanthanum fluoride film 104, and magnesium fluoride film 105 can also be formed by vacuum evaporation or the like.

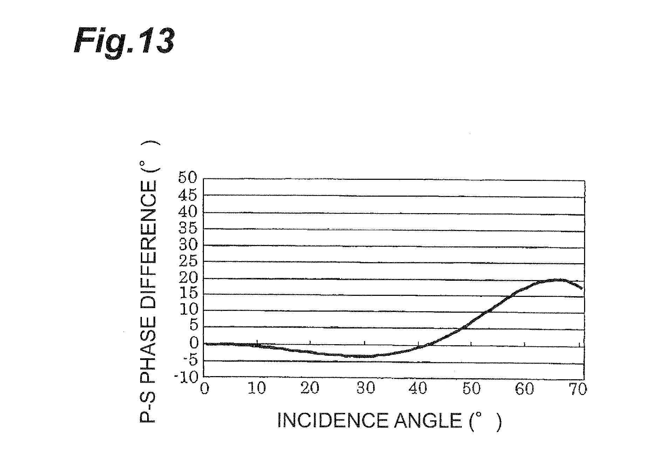

Fig. 13 is a drawing showing a relation of incidence angle versus phase difference of rays on a deflecting plane mirror to which the reflecting surface structure according to the modification example of Fig. 12 is applied. In Fig. 13, similar to Figs. 9 and 11, the horizontal axis represents incidence angles (°) and the vertical axis p-s phase shifts (°) due to polarization directions. However, Figs. 9 and 11 have the vertical axis representing absolute values (°) of p-s phase shifts, whereas Fig. 13 has the vertical axis representing values (°) including signs of p-s phase shifts. With reference to Fig. 13, it is seen that the p-s phase shifts due to polarization directions are controlled to below about 21° across a wide incidence angle range of 0° to about 70°.

Since the modification example of Fig. 12 adopts the reflecting surface structure having the metal layer (aluminum film 102) formed on the glass substrate 101 as a base material, and the three dielectric layers (magnesium fluoride film 103, lanthanum fluoride film 104, and magnesium fluoride film 105) formed on the metal layer, it is feasible to control the phase differences due to polarization directions (p-s phase shifts due to polarization directions) to a low level across the incidence angle range of light and to control performance variation (degradation) of the reflecting surface due to laser irradiation to a low level. The number of dielectric layers formed on the metal layer does not have to be limited to three, and, for example, a reflecting surface structure with four dielectric layers on the metal layer can also achieve much the same effect as in the modification example of Fig. 12.

As described above, the present embodiment is arranged to apply the reflecting surface structure shown in Fig. 8, to the first deflecting plane mirror M11 and the second deflecting plane mirror M12 in the projection optical system PL. Therefore, the first deflecting plane mirror M11 and the second deflecting plane mirror M12 each are so arranged that the change from the phase difference between the p-polarized incident light and the s-polarized incident light to the reflecting surface, to the phase difference between the reflected light of the p-polarized incident light and the reflected light of the s-polarized incident light to the reflecting surface, i.e., the p-s phase shift due to polarization directions on the first deflecting plane mirror M11 and the second deflecting plane mirror M12 is within 30° for all the rays incident to the reflecting surface.

As a result, while the projection optical system PL of the present embodiment includes the reflecting mirrors to which rays are incident across a relatively wide incidence angle range (i.e., the first deflecting plane mirror M11 and the second deflecting plane mirror M12), it is able to well suppress the change in the polarization state in the optical path of the light beam incident substantially as linearly polarized light. Therefore, the exposure apparatus of the present embodiment is able to well suppress the change in the polarization state in the projection optical system PL for the light beam incident substantially as linearly polarized light, for example, in the case of the circumferential polarization annular illumination or the like, and to effect faithful exposure while forming a high-contrast image of the microscopic pattern of the mask on the photosensitive substrate.

In the projection optical system PL of the present embodiment, in order to improve the contrast of the pattern image and well suppress variation in resolution or resolved line width (e.g., error of line width between vertical and horizontal patterns), it is preferable to apply the reflecting surface structure shown in Fig. 10 or in Fig. 12, to the first deflecting plane mirror M11 and the second deflecting plane mirror M12 in the projection optical system PL so that the p-s phase shift due to polarization directions on the first deflecting plane mirror M11 and the second deflecting plane mirror M12 falls within 20° for all the rays incident to the reflecting surface.

In the projection optical system PL of the present embodiment, in order to improve the contrast of the pattern image and well suppress variation in resolution, it is preferable to arrange the first deflecting plane mirror M11 and the second deflecting plane mirror M12 so that a change from a phase difference between two rays before incidence to the reflecting surface of the first deflecting plane mirror M11, to a phase difference between the two rays after reflection on the reflecting surface of the second deflecting plane mirror M12 is within 50° for any two rays incident to the reflecting surface of the first deflecting plane mirror M11.

In this case, in terms of improvement in contrast and suppression of variation in resolution, it is further preferable that the change from the phase difference between two rays before incidence to the reflecting surface of the first deflecting plane mirror M11, to the phase difference between the two rays after reflection on the reflecting surface of the second deflecting plane mirror M12 be within 40° for any two rays incident to the reflecting surface of the first deflecting plane mirror M11.

Incidentally, for example, with the first deflecting plane mirror M11 and the second deflecting plane mirror M12 in the projection optical system PL of the present embodiment, the change amount y (°) from the phase difference between p-polarized incident light to the reflecting surface and s-polarized incident light to the reflecting surface, to the phase difference between reflected light of the p-polarized incident light to the reflecting surface and reflected light of the s-polarized incident light to the reflecting surface is approximated by Eq (2) below, where x (°) represents an angle of incidence of light to the reflecting surface.

$$ y = C_1 x + C_2 x^2 + C_3 x^3 + C_4 x^4 + C_5 x^5 + ... \qquad (2) $$

Here the change amount y (°) does not correspond to the absolute value of p-s phase shift on the vertical axis in Figs. 9 and 11, but corresponds to the value (°) including the sign of p-s phase shift on the vertical axis in Fig. 13. At this time, preferably, a P-V (peak to valley: difference between a maximum and a minimum) value of a quantity $y' = C_2 x^2 + C_3 x^3 + C_4 x^4 + C_5 x^5 + ...$ resulting from subtraction of the first-order term $C_1 x$ in Eq (2) from the change amount y is controlled to not more than 25° in an incidence angle range of effective rays incident to the reflecting surface. This configuration is able to well suppress the change in the polarization state in the optical path of the light beam incident substantially as linearly polarized light and eventually to well maintain the imaging performance of the projection optical system PL while the projection optical system PL includes the reflecting mirrors to which rays are incident across a relatively wide incidence angle range (the first deflecting plane mirror M11 and the second deflecting plane mirror M12).

In order to better exercise the above effect of the present invention, the foregoing P-V value of the quantity $y' = C_2 X^2 + C_3 X^3 + C_4 X^4 + C_5 X^5 + ...$ is more preferably controlled to not more than 20° in the incidence angle range of effective rays incident to the reflecting surface. The below will briefly describe the reason why the first-order term $C_1 x$ in Eq (2) is excluded from the change amount y. For example, in the projection optical systems PL shown in Figs. 5 to 7, a difference between a maximum incidence angle and a minimum incidence angle of rays incident to the reflecting surface of each of the deflecting plane mirrors M11 and M12 is not less than 20° and a ray incident at the incidence angle of about 70° to the first deflecting plane mirror M11 is incident at the incidence angle of about 30° to the second deflecting plane mirror M12. Namely, rays incident at large incidence angles to the first deflecting plane mirror M11 are incident at small incidence angles to the second deflecting plane mirror M12, and thus influence of the first-order term $C_1 x$ in Eq (2) is small and ignorable.

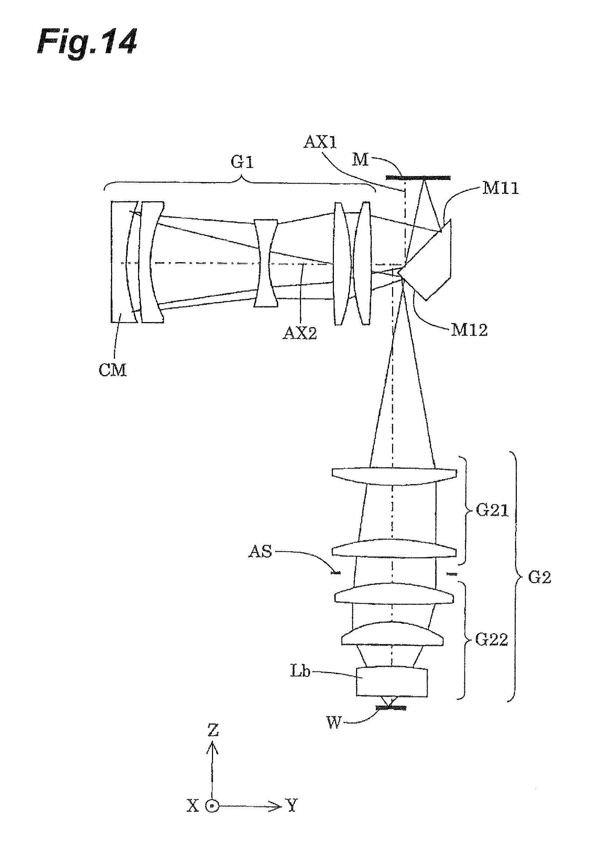

In the above-described embodiment, the projection optical systems PL shown in Figs. 5 to 7 are constructed as so-called dry type optical systems. However, without having to be limited to this, for example, the projection optical system PL shown in Fig. 5 and the projection optical system PL shown in Fig. 7 may be constructed as so-called liquid immersion type optical systems. Fig. 14 is a drawing schematically showing a configuration of a liquid immersion type projection optical system corresponding to the projection optical system shown in Fig. 5.

The liquid immersion type projection optical system PL shown in Fig. 14 is provided with a catadioptric first imaging optical system G1 for forming an intermediate image of the pattern on the mask M. The first imaging optical system G1 has a concave reflecting mirror CM, a plurality of lenses, and a first deflecting plane mirror M11 and forms the intermediate image on the basis of the light beam from the mask M. A second deflecting plane mirror M12 is located near the formation position of the intermediate image formed by the first imaging optical system G1.

The second deflecting plane mirror M12 deflects the light beam to the intermediate image or the light beam from the intermediate image toward a refracting second imaging optical system G2. The second imaging optical system G2 forms a final image (reduced image) of the pattern of the mask M on the wafer W, based on the light beam from the intermediate image. The first deflecting plane mirror M11 and the second deflecting plane mirror M12 both have their respective planar reflecting surfaces and are integrally constructed as a single optical member (one path folding mirror) having the two reflecting surfaces.

Furthermore, the second imaging optical system G2 is composed of a lens unit G21 with a positive refractive power, an aperture stop AS, and a lens unit G22 with a positive refractive power which are disposed in the optical path between the second deflecting plane mirror M12 and the wafer W and which are arranged in order from the second deflecting plane mirror M12 side. A lens closest to the wafer W in the lens unit G22 (i.e., an optical member with refractive power) constitutes a boundary lens Lb.

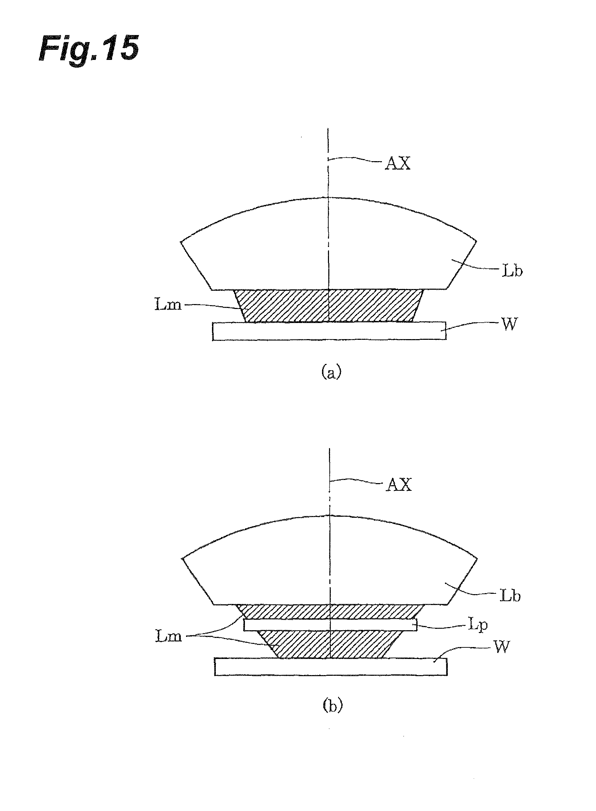

Fig. 15 is a drawing schematically showing configurations between the boundary lens and the wafer in the liquid immersion type projection optical system. In the liquid immersion type projection optical system PL, as shown in Fig. 15 (a), the optical path between the boundary lens Lb with a positive refractive power and the wafer W is filled with a liquid (medium) Lm, for example, pure water. In other words, the predetermined liquid Lm fills the optical path between the wafer W and the boundary lens Lb being the optical member located nearest to the image side (wafer W side) among the optical members with refractive power in the projection optical system PL.

However, it is also possible to adopt a configuration, as shown in a modification example in Fig. 15 (b), wherein a plane-parallel plate Lp is arranged as freely inserted into or retracted from the optical path between the boundary lens Lb and the wafer W and wherein the optical path between the boundary lens Lb and the plane-parallel plate Lp and the optical path between the plane-parallel plate Lp and the wafer W are filled with a liquid Lm, for example, pure water. In this case, even if the liquid Lm is contaminated by a photoresist or the like applied onto the wafer W, the plane-parallel plate (generally, an optical member having substantially no refractive power) Lp replaceably interposed between the boundary lens Lb and the wafer W acts to effectively prevent the image-side optical surface of the boundary lens Lb from being contaminated by the contaminated liquid Lm.

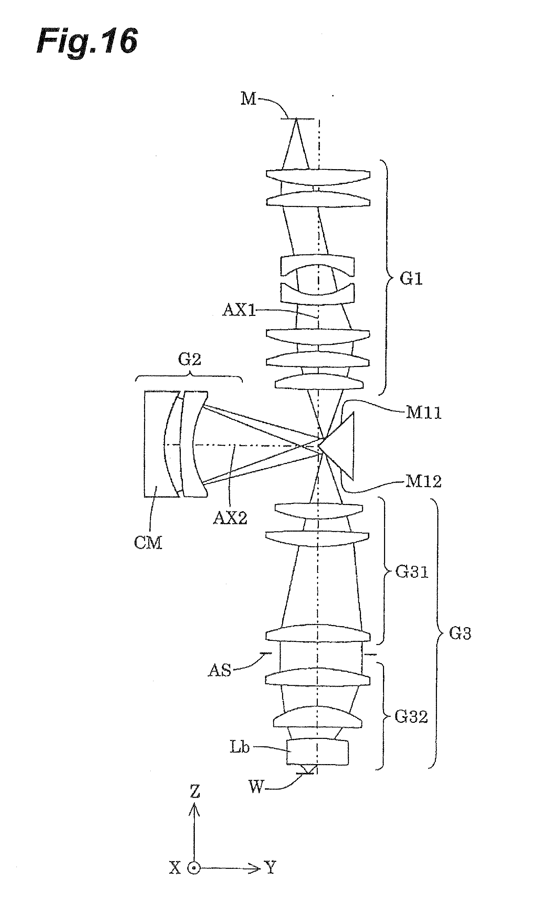

Fig. 16 is a drawing schematically showing a configuration of another liquid immersion type projection optical system corresponding to the projection optical system shown in Fig. 7. The liquid immersion type projection optical system PL shown in Fig. 16 is provided with a refracting first imaging optical system G 1 for forming a first intermediate image of the pattern on the mask M. A first deflecting plane mirror M11 is located near the formation position of the first intermediate image formed by the first imaging optical system G1 (a position optically conjugate with the first surface (second surface)). The first deflecting plane mirror M11 deflects the light beam to the first intermediate image or the light beam from the first intermediate image toward a catadioptric second imaging optical system G2.

The second imaging optical system G2 has a concave reflecting mirror CM and a lens unit and forms a second intermediate image on the basis of the light beam from the first intermediate image. A second deflecting plane mirror M12 is located near the formation position of the second intermediate image formed by the first imaging optical system G1 (a position optically conjugate with the first surface (second surface)). The second deflecting plane mirror M12 deflects the light beam to the second intermediate image or the light beam from the second intermediate image, toward a refracting third imaging optical system G3. The third imaging optical system G3 forms a final image (reduced image) of the pattern of the mask M on the wafer W, based on the light beam from the second intermediate image.

Specifically, the third imaging optical system G3 is composed of a lens unit G31 with a positive refractive power, an aperture stop AS, and a lens unit G32 with a positive refractive power, which are arranged in order from the second deflecting plane mirror M12 side. A lens closest to the wafer W in the lens unit G32 (i.e., an optical member with refractive power) constitutes a boundary lens Lb. The first deflecting plane mirror M1 and the second deflecting plane mirror M12 both have their respective planar reflecting surfaces and are integrally constructed as a single optical member (one path folding mirror) having the two reflecting surfaces. The positions optically conjugate with the first surface (second surface) lie on the optical path of the first deflecting plane mirror M11 on the concave reflecting mirror CM side and on the optical path of the second deflecting plane mirror M12 on the concave reflecting mirror CM side.

In the exposure apparatus of the step-and-scan method of performing scanning exposure while moving the wafer W relative to the projection optical system PL, the liquid Lm can be continuously kept in the optical path between the boundary lens Lb of the projection optical system PL and the wafer W from start to finish of the scanning exposure, for example, by the technology disclosed in International Publication WO99/49504 or by the technology disclosed in Japanese Patent Application Laid-Open No. 10-303114.

In the technology disclosed in WO99/49504, a liquid supply device supplies the liquid controlled at a predetermined temperature, through a supply tube and a discharge nozzle so as to fill the optical path between the boundary lens Lb and the wafer W and the liquid supply device recovers the liquid from on the wafer W through a recovery tube and an input nozzle. On the other hand, in the technology disclosed in Laid-Open No. 10-303114, a wafer holder table is constructed in such a receptacle shape as to receive the liquid and the wafer W is positioned and held by vacuum suction in the center of an inner bottom portion of the holder table (i.e., in the liquid). The exposure apparatus is so arranged that the tip of the barrel of the projection optical system PL is located in the liquid and the optical surface of the boundary lens Lb on the wafer side is thus located in the liquid.

The liquid immersion type projection optical systems PL shown in Figs. 14 and 16 are optical systems for forming a reduced image of an effective field region on the mask (first surface) M illuminated with nearly linearly polarized light, on the wafer (second surface) W. The liquid immersion type projection optical systems PL shown in Figs. 14 and 16 are comprised of the first deflecting plane mirror M11 disposed in the optical path between the mask M and the wafer W; the partial optical system (G1; G2) disposed in the optical path between the first deflecting plane mirror M11 and the wafer W and including the concave reflecting mirror CM; the second deflecting plane mirror M12 disposed in the optical path between the partial optical system (G1 ; G2) and the wafer W; the first lens unit (G21; G31) with the positive refractive power disposed in the optical path between the second deflecting plane mirror M12 and the wafer W; the aperture stop AS disposed in the optical path between the first lens unit (G21; G31) and the wafer W; and the second lens unit (G22; G32) with the positive refractive power disposed in the optical path between the aperture stop AS and the wafer W.

In the liquid immersion type projection optical systems PL shown in Figs. 14 and 16, the predetermined liquid fills the optical path between the wafer W and the boundary lens Lb located nearest to the wafer W among the optical members with refractive power in the projection optical system PL. The liquid immersion type projection optical system PL shown in Fig. 16 further has the first imaging optical system G1 as a third lens unit disposed in the optical path between the mask M and the first deflecting plane mirror M11. In Figs. 14 and 16, the Z-axis is set along a direction of a normal to the pattern surface of the mask M, the X-axis along a direction normal to a plane made by the entrance axis AX1 and the exit axis AX2 of the first deflecting plane mirror M11 (i.e., the plane of Fig. 14 and the plane of Fig. 16), and the Y-axis along a direction perpendicular to the Z-axis and to the X-axis.

In the exposure apparatus using the catadioptric liquid immersion type projection optical system PL including the two deflecting plane mirrors M11 and M12 as shown in Figs. 14 and 16, the pattern region on the mask M is generally comprised of a mixture of patterns extending oblongly in a direction (X-direction) parallel to a line of intersection between the reflecting surface of the first deflecting plane mirror M11 and the reflecting surface of the second deflecting plane mirror M12 (generally, a line of intersection between a plane virtually extended from the reflecting surface of the first deflecting plane mirror M11 and a plane virtually extended from the reflecting surface of the second deflecting plane mirror M12), i.e., X-directional patterns, and patterns extending oblongly in a direction (Y-direction) perpendicular to the above line of intersection, i.e., Y-directional patterns.

However, the pattern region on the mask M can also include a relatively large number of patterns extending obliquely and oblongly at 45° and 135° relative to the X-axis in the XY plane, i.e., oblique patterns mixed. In this case, the liquid immersion type projection optical systems PL shown in Figs. 14 and 16 are preferably so arranged that the ratio S2/S0 of the component S2 to the component S0 among the Stokes parameters is not less than 0.9 for rays distributed in directions at 45° and 135° relative to the X-axis in the XY plane, among the rays incident to the mask (first surface) M.

This configuration makes it feasible to guide linearly polarized light vibrating in the longitudinal direction of the oblique patterns, onto the oblique patterns and, eventually, to form a high-contrast image of the oblique patterns in a nearly s-polarized state (polarization state in which the principal component is s-polarized light) on the wafer W. In other words, even if the p-s phase shifts due to polarization directions are reduced to a low level on the deflecting plane mirrors M11 and M12, and if the ratio S2/S0 of the component S2 to the component S0 among the Stokes parameters is below 0.9 for the rays distributed in the directions at 45° and 135° relative to the X-axis in the XY plane, the light in the desired linear polarization state cannot be guided to the oblique patterns and the contrast will degrade of the oblique pattern image formed on the wafer W.

In this case, for all the rays distributed in the directions at 45° and 135° relative to the X-axis on the entrance pupil surface (lens aperture) of the projection optical system PL, preferably, a change from a phase difference between p-polarized incident light to the reflecting surface of the first deflecting plane mirror M11 and s-polarized incident light to the reflecting surface of the first deflecting plane mirror M11, to a phase difference between reflected light of the p-polarized incident light to the reflecting surface of the first deflecting plane mirror M11 and reflected light of the s-polarized incident light to the reflecting surface of the first deflecting plane mirror M11 is controlled to not more than 30°, and a change from a phase difference between p-polarized incident light to the reflecting surface of the second deflecting plane mirror M12 and s-polarized incident light to the reflecting surface of the second deflecting plane mirror M12, to a phase difference between reflected light of the p-polarized incident light to the reflecting surface of the second deflecting plane mirror M12 and reflected light of the s-polarized incident light to the reflecting surface of the second deflecting plane mirror M12 is also controlled to not more than 30°.

In other words, for all the rays distributed in the directions at 45° and 135° relative to the X-axis on the entrance pupil surface (lens aperture) of the projection optical system PL, the p-s phase shifts due to polarization directions are preferably controlled to not more than 30° in both of the first deflecting plane mirror M11 and the second deflecting plane mirror M12. This configuration makes it feasible to well control the change in the polarization state in the optical path of the projection optical system PL with incidence of linearly polarized light vibrating in the longitudinal direction of the oblique patterns, thereonto, and, eventually, to form a high-contrast image of the oblique patterns in a nearly s-polarized state on the wafer W. In order to better exercise the above effect of the present invention, the aforementioned p-s phase shifts are more preferably controlled to not more than 20° in both of the first deflecting plane mirror M11 and the second deflecting plane mirror M12.

In the aforementioned embodiment and modification examples, the aluminum film is used as the metal layer in the reflecting surface structures shown in Figs. 8, 10, and 12. However, the metal layer does not have to be limited to this, but may be made, for example, using a substance selected from the group consisting of Ag (silver), Si (silicon), Ge (germanium), Mo (molybdenum), and Ru (ruthenium).

In the aforementioned embodiment and modification examples, the magnesium fluoride film and the lanthanum fluoride film are used as the dielectric layers in the reflecting surface structures shown in Figs. 8, 10, and 12. However, the dielectric layers do not have to be limited to these, but may be made, for example, using a substance selected from the group consisting of $NdF_3$ (neodymium fluoride), $YF_3$ (yttrium fluoride), $GdF_3$ (gadolinium fluoride), $AlF_3$ (aluminum fluoride), $Na_3AlF_6$ (cryolite), $CaF_2$ (calcium fluoride), $SrF_2$ (strontium fluoride), $DyF_3$ (dysprosium fluoride), $HfF_4$ (hafnium fluoride), $LuF_3$ (lutetium fluoride), $Al_2O_3$ (aluminum oxide), $HfO_2$ (hafnium oxide), $ZrO_2$ (zirconium oxide), $TiO_2$ (titanium oxide), $Nb_2O_5$ (niobium oxide), $Ta_2O_5$ (tantalum oxide), $SiO_2$ (silicon oxide), and $Y_2O_3$ (yttrium oxide).

In the foregoing description, the present invention was described with focus on the projection optical system PL, but it is noted that the present invention is also similarly applicable to the illumination optical system (11-M22) disposed in the optical path between the polarization converting element 10 and the mask M and, eventually, to the optical system (11-PL) disposed in the optical path between the polarization converting element 10 and the wafer W. Namely, if the polarization state of light undergoes relatively large change in the optical path of the illumination optical system (11-M22) because of the phase shifts due to polarization directions on the deflecting plane mirror M21 and on the deflecting plane mirror M22, the light will fail to be focused in the desired linear polarization state (polarization state in which the principal component is s-polarized light) on the wafer W and this could degrade the imaging performance.

In the present embodiment, therefore, the reflecting surface structure shown in Fig. 8 is applied to the deflecting plane mirror M21 and the deflecting plane mirror M22 in the illumination optical system (11-M22). Accordingly, the deflecting plane mirrors M21 and M22 each are so arranged that a change from a phase difference between p-polarized incident light and s-polarized incident light to the reflecting surface, to a phase difference between reflected light of the p-polarized incident light and reflected light of the s-polarized incident light to the reflecting surface, i.e., p-s phase shift due to polarization directions on the deflecting plane mirrors M21 and M22 is within 30° for all the rays incident to the reflecting surface.

As a result, while the illumination optical system (11-M22) includes the reflecting mirrors (deflecting plane mirrors M21 and M22) to which rays are incident across a relatively wide incidence angle range, it is able to well suppress the change in the polarization state in the optical path of the light beam incident substantially as linearly polarized light. Therefore, for example, when the exposure apparatus of the present embodiment is used to perform the circumferential polarization annular illumination or the like, the change in the polarization state is well suppressed for the light beam incident substantially as linearly polarized light in the illumination optical system (11-M22) and faithful exposure is effected by forming a high-contrast image of the microscopic pattern of the mask on the photosensitive substrate.

In the illumination optical system (11-M22) of the present embodiment, in order to improve the contrast of the pattern image and well suppress the variation in resolution (line width error), it is preferable to apply the reflecting surface structure shown in Fig. 10, to the deflecting plane mirrors M21 and M22 in the illumination optical system (11-M22) so that each of the deflecting plane mirrors is so arranged that the p-s phase shift due to polarization directions on the deflecting plane mirrors M21 and M22 is within 20° for all the rays incident to the reflecting surface.

In the illumination optical system (11-M22) of the present embodiment, in order to improve the contrast of the pattern image and well suppress the variation in resolution, it is preferable to arrange the deflecting plane mirrors M21 and M22 so that a change from a phase difference between two rays before incidence to the reflecting surface of the deflecting plane mirror M21, to a phase difference between the rays after reflection on the reflecting surface of the deflecting plane mirror M22 is within 50° for any two rays incident to the reflecting surface of the deflecting plane mirror M21.

In this case, in terms of improvement in contrast and suppression of resolution variation, it is further preferable that the change from the phase difference between two rays before incidence to the reflecting surface of the deflecting plane mirror M21, to the phase difference between the two rays after reflection on the reflecting surface of the deflecting plane mirror M22 be within 40° for any two rays incident to the reflecting surface of the deflecting plane mirror M21.

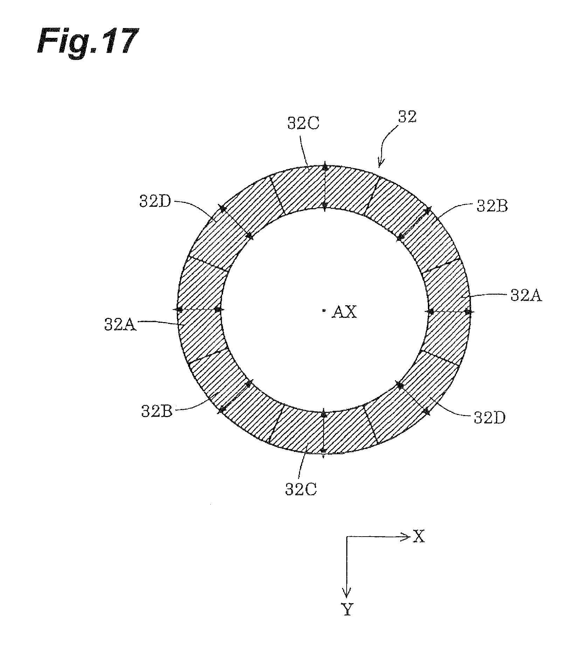

Incidentally, the present embodiment permits radial polarization annular illumination (off-axis illumination in which beams passing through the annular secondary light source are set in a radial polarization state) in such a manner that linearly polarized light having the polarization direction along the X-direction is made incident to the polarization converting element 10 to let the light beams pass in the radial polarization state through the annular secondary light source 32 as shown in Fig. 17. In the radial polarization state, the light beams passing through respective arcuate regions 32A-32D constituting the annular secondary light source 32 are in a linear polarization state with the polarization direction approximately coincident with a radial direction of a circle centered around the optical axis AX, at the center position along the circumferential direction of each arcuate region 32A-32D.

In the radial polarization annular illumination based on the annular illumination pupil distribution in the radial polarization state, the light projected onto the wafer W as a final surface to be illuminated is in a polarization state in which the principal component is p-polarized light. The p-polarized light herein is linearly polarized light having the polarization direction along a direction parallel to the plane of incidence defined as described previously (i.e., polarized light whose electric vector vibrates in the direction parallel to the plane of incidence). As a result, the radial polarization annular illumination allows us to obtain a good mask pattern image on the wafer (photosensitive substrate) while controlling the reflectance of light to a low level on the resist applied to the wafer W.

The foregoing embodiment is arranged to switch the light beam incident to the polarization converting element 10 between the linear polarization state having the polarization direction along the Y-direction and the linear polarization state having the polarization direction along the X-direction, thereby implementing the circumferential polarization annular illumination and the radial polarization annular illumination. However, how to implement the circumferential polarization annular illumination and the radial polarization annular illumination is not limited to this method, but it is also possible to implement the circumferential polarization annular illumination and the radial polarization annular illumination, for example, by switching the polarization converting element 10 between a first state of the polarization converting element 10 shown in Fig. 2 and a second state in which the polarization converting element 10 is rotated by 90° around the optical axis AX from the first state, for the incident beam in the linear polarization state having the polarization direction along the Y-direction or along the X-direction.

In the foregoing embodiment, the polarization converting element 10 is disposed immediately before the micro fly's eye lens 11. However, without having to be limited to this, the polarization converting element 10 may also be located generally on or near the illumination pupil; for example, on or near the pupil of the projection optical system PL, on or near the pupil of the imaging optical system 15, or immediately before the conical axicon system 8 (on or near the pupil of the afocal lens 6).

However, if the polarization converting element 10 is located in the projection optical system PL or in the imaging optical system 15, the required effective diameter of the polarization converting element 10 will tend to become large and thus this configuration is not so preferable in view of the present status that it is difficult to obtain a large rock crystal substrate with high quality. When the polarization converting element 10 is disposed immediately before the conical axicon system 8, the required effective diameter of the polarization converting element 10 can be kept small, but the distance becomes longer to the wafer W being the final surface to be illuminated, to raise a possibility that an element to change the polarization state, such as an antireflection coat on a lens or a reflecting film of a mirror, is interposed in the optical path to the wafer, which is not so preferred.

In the foregoing embodiment, at least one surface of the polarization converting element 10 (e.g., the exit surface) is uneven and the polarization converting element 10 has the thickness distribution varying discretely (discontinuously) in the circumferential direction eventually. However, without having to be limited to this, at least one surface of the polarization converting element 10 (e.g., the exit surface) can be formed in such a curved shape that the polarization converting element 10 has a thickness distribution varying approximately discontinuously in the circumferential direction.

In the foregoing embodiment, the polarization converting element 10 is constructed of the eight basic elements of the sector shape corresponding to the eight segments of the annular effective region. However, without having to be limited to this, the polarization converting element 10 can also be constructed of eight basic elements of a sector shape corresponding to eight segments of a circular effective region, or of four basic elements of a sector shape corresponding to four segments of a circular or annular effective region, or of sixteen basic elements of a sector shape corresponding to sixteen segments of a circular or annular effective region. Namely, it is possible to adopt a variety of modification examples as to the shape of the effective region of the polarization converting element 10, the number of segments of the effective region (the number of basic elements), and so on.

In the foregoing embodiment, each of the basic elements 10A-10D (consequently, the polarization converting element 10) is made of rock crystal. However, without having to be limited to this, each basic element can also be made of another appropriate optical material with optical rotatory power. In this case, it is preferable to use an optical material with the optical rotatory power of not less than 100°/mm for the light of wavelength used. Namely, it is not preferable to use an optical material with a small value of optical rotatory power because the thickness enough to obtain the required rotation angle of the polarization direction becomes so large as to cause loss in quantity of light.

In the foregoing embodiment, the polarization converting element 10 is fixed relative to the illumination optical path, but this polarization converting element 10 may be so arranged that it can be inserted into and retracted from the illumination optical path. The foregoing embodiment showed the example of the combination of the annular illumination with s-polarized light for the wafer W, but it is also possible to adopt one of combinations of multi-pole illuminations, such as dipole illumination and quadrupole illumination, and circular illumination with s-polarized light for the wafer W. In the foregoing embodiment, the illumination conditions for the mask M and the imaging conditions (numerical aperture, aberration, etc.) for the wafer W can be automatically set, for example, according to the type of the pattern of the mask M or the like.

The foregoing embodiment is arranged to effect unpolarized circular illumination in such a manner that the depolarizer 4c is inserted into the illumination optical path and that a diffractive optical element for circular illumination is set in the illumination optical path instead of the diffractive optical element 5 for annular illumination. In this case, unpolarized light is incident to the polarization converting element 10. When the unpolarized light is incident to each basic element 10A-10D, it is outputted as unpolarized light; and when the unpolarized light is incident to the center region 10E, it is also outputted as unpolarized light. For effecting small-$\sigma$ circular illumination with linearly polarized light, the depolarizer 4c is retraced from the illumination optical path, the diffractive optical element for circular illumination is set in the illumination optical path instead of the diffractive optical element 5 for annular illumination, and the focal length of the zoom lens 9 is so set as to project light only to the center region 10E of the polarization converting element 10. At this time, the polarization direction of linearly polarized light in the small-$\sigma$ circular illumination can be arbitrarily set by properly setting the rotational angle position of the crystallographic axis of the half-wave plate 4b around the optical axis.

In the foregoing embodiment, where the optical system (the illumination optical system or the projection optical system) on the wafer W side with respect to the polarization converting element 10 has polarization aberration (retardation), this polarization aberration can cause change in the polarization direction. In this case, the direction of the polarization plane rotated by the polarization converting element 10 may be set in view of the influence of polarization aberration of these optical systems. If a reflecting member is disposed in the optical path on the wafer W side with respect to the polarization converting element 10, a phase difference can arise for every polarization direction of reflection by this reflecting member. In this case, the direction of the polarization plane rotated by the polarization converting element 10 may be set in view of the phase difference of the light beam caused by the polarization characteristic of the reflecting surface. The illumination optical system in the foregoing embodiment may be, for example, the illumination optical system disclosed in International Publication WO2005/036619, the illumination optical system proposed in International Application PCT/JP2004/016247, or the illumination optical system disclosed in U.S. Published Application No. 2004/012764.

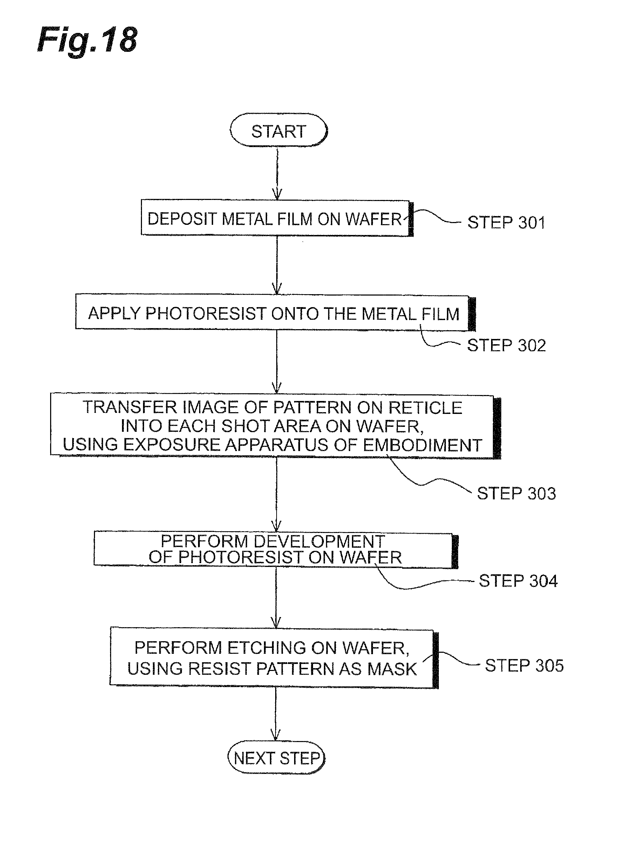

The exposure apparatus of the foregoing embodiment can be used to fabricate micro devices (semiconductor devices, image pickup devices, liquid-crystal display devices, thin-film magnetic heads, etc.) by illuminating a mask (reticle) by the illumination optical apparatus (illumination step) and projecting a pattern to be transferred, formed in the mask, onto a photosensitive substrate with the projection optical system (exposure step). An example of a technique of forming a predetermined circuit pattern in a wafer or the like as a photosensitive substrate with the exposure apparatus of the foregoing embodiment to obtain semiconductor devices as micro devices will be described below with reference to the flowchart of Fig. 18.

The first step 301 in Fig. 18 is to deposit a metal film on each wafer in one lot. The next step 302 is to apply a photoresist onto the metal film on each wafer in the lot. The subsequent step 303 is to sequentially transfer an image of a pattern on the mask into each shot area on each wafer in the lot through the projection optical system, using the exposure apparatus of the foregoing embodiment. The subsequent step 304 is to perform development of the photoresist on each wafer in the lot and the subsequent step 305 is to perform etching on each wafer in the lot, using the resist pattern as a mask, and thereby to form a circuit pattern corresponding to the pattern on the mask, in each shot area on each wafer. Subsequent steps include formation of circuit patterns in upper layers, and others, thereby fabricating devices such as semiconductor devices. The above-described semiconductor device fabrication method permits us to obtain semiconductor devices with extremely fine circuit patterns at high throughput.

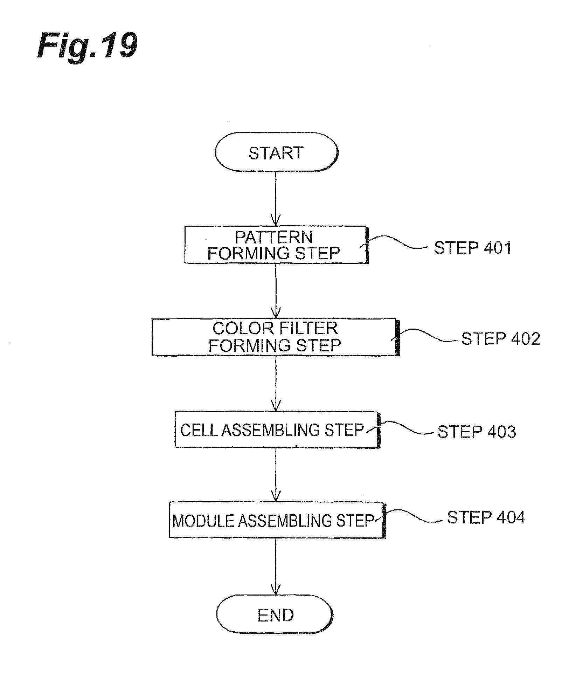

The exposure apparatus of the foregoing embodiment can also be used to fabricate a liquid-crystal display device as a micro device by forming predetermined patterns (circuit pattern, electrode pattern, etc.) on plates (glass substrates). An example of a technique in this case will be described with reference to the flowchart of Fig. 19. In Fig. 19, a pattern forming step 401 is to execute a so-called photolithography step to transfer a pattern of a mask onto a photosensitive substrate (glass substrate coated with a resist, or the like) with the exposure apparatus of the foregoing embodiment. This photolithography step results in forming the predetermined pattern including a number of electrodes and others on the photosensitive substrate. Thereafter, the exposed substrate is subjected to each of steps such as development, etching, and resist removal, whereby a predetermined pattern is formed on the substrate. Thereafter, the process shifts to the next color filter forming step 402.

The next color filter forming step 402 is to form a color filter in which a number of sets of three dots corresponding to R (Red), G (Green), and B (Blue) are arrayed in a matrix pattern, or in which sets of three stripe filters of R, G, and B are arrayed as a plurality of lines along the horizontal scan line direction. After completion of the color filter forming step 402, a cell assembling step 403 is carried out. The cell assembling step 403 is to assemble a liquid crystal panel (liquid crystal cell), using the substrate with the predetermined pattern obtained in the pattern forming step 401, the color filter obtained in the color filter forming step 402, and so on.

In the cell assembling step 403, for example, a liquid crystal is poured into between the substrate with the predetermined pattern obtained in the pattern forming step 401 and the color filter obtained in the color filter forming step 402, to fabricate a liquid crystal panel (liquid crystal cell). The subsequent module assembling step 404 is to install each of components such as an electric circuit, a backlight, etc. for display operation of the assembled liquid crystal panel (liquid crystal cell) to complete the liquid-crystal display device. The above-described method of fabricating the liquid-crystal display device permits us to obtain the liquid-crystal display device with an extremely fine circuit pattern at high throughput.

In the foregoing embodiment the exposure light was the ArF excimer laser light (wavelength: 193 nm), but, without having to be limited to this, the present invention can also be applied to the other appropriate laser light sources, e.g., a KrF excimer laser light source for supplying light of wavelength of 248 nm or an $F_2$ laser light source for supplying laser light of wavelength of 157 nm.

In the foregoing embodiment, it is also possible to adopt a technique of filling the optical path between the projection optical system and the photosensitive substrate with a medium having the refractive index of more than 1.1 (typically, a liquid), i.e., the so-called liquid immersion method. In this case, the technique of filling the liquid in the optical path between the projection optical system and the photosensitive substrate can be one selected from the method of locally filling the space with the liquid as disclosed in International Publication WO99/49504, the method of moving a stage holding a substrate as an exposed object, in a liquid bath as disclosed in Japanese Patent Application Laid-Open No. 6-124873, the method of forming a liquid bath of a predetermined depth on a stage and holding a substrate in the liquid bath as disclosed in Japanese Patent Application Laid-Open No. 10-303114, and so on.

The liquid is preferably one that is transparent to exposure light, that has the refractive index as high as possible, and that is stable against the projection optical system and the photoresist applied on the surface of the substrate; for example, where the KrF excimer laser light or the ArF excimer laser light is used as exposure light, the liquid can be pure water or deionized water. Where the exposure light is the $F_2$ laser light, the liquid can be a fluorine-based liquid, for example, such as fluorine oil or perfluoro polyether (PFPE) capable of transmitting the $F_2$ laser light.

**Description of Reference Symbols**

| | |
|---|---|
| 1 | light source |
| 4 | polarization state switch |
| 4a | quarter-wave plate |
| 4b | half-wave plate |
| 4c | depolarizer |
| 5 | diffractive optical element (beam converting element) |
| 6 | afocal lens |
| 8 | conical axicon system |
| 9 | zoom lens |
| 10 | polarization converting element |
| 10A-10D | basic elements |
| 11 | micro fly's eye lens |
| 12 | polarization monitor |
| 12a | beam splitter |
| 13 | condenser optical system |
| 14 | mask blind |
| 15 | imaging optical system |
| M | mask |
| PL | projection optical system |
| W | wafer |
| M11, M12, M21, M22 | deflecting plane mirrors |
| G1 | first imaging optical system |
| G2 | second imaging optical system |
| G3 | third imaging optical system |

**Claims**

1. An optical system which comprises at least one reflecting mirror and to which a substantially linearly polarized beam is incident,
   wherein a maximum incidence angle of rays incident to a reflecting surface of the reflecting mirror is not less than 20°, and
wherein the reflecting mirror is so arranged that a change from a phase difference between p-polarized incident light to the reflecting surface and s-polarized incident light to the reflecting surface, to a phase difference between reflected light of the p-polarized incident light to the reflecting surface and reflected light of the s-polarized incident light to the reflecting surface is within 30° for all the rays incident to the reflecting surface.

2. The optical system according to claim 1, wherein the reflecting mirror has a metal layer formed on a substrate, and at least one dielectric layer formed on the metal layer.

3. The optical system according to claim 2, wherein said at least one dielectric layer comprises three or four dielectric layers.

4. The optical system according to any one of claims 1 to 3, wherein the metal layer contains a substance selected from the group consisting of Ag, Al, Si, Ge, Mo, and Ru.

5. The optical system according to any one of claims 1 to 4, wherein the dielectric layer contains a substance selected from the group consisting of $MgF_2$, $LaF_3$, $NdF_3$, $YF_3$, $GdF_3$, $AlF_3$, $Na_3AlF_6$, $CaF_2$, $SrF_2$, $DyF_3$, $HfF_4$, $LuF_3$, $Al_2O_3$, $HfO_2$, $ZrO_2$, $TiO_2$, $Nb_2O_5$, $Ta_2O_5$, $SiO_2$, and $Y_2O_3$.

6. The optical system according to any one of claims 1 to 5, wherein the reflecting mirror is a deflecting plane mirror for folding an optical path.

7. The optical system according to any one of claims 1 to 6, wherein when an amount y (°) of the change from the phase difference between the p-polarized incident light to the reflecting surface of the reflecting mirror and the s-polarized incident light to the reflecting surface, to the phase difference between the reflected light of the p-polarized incident light to the reflecting surface of the reflecting mirror and the reflected light of the s-polarized incident light to the reflecting surface is approximated by $y = C_1x + C_2x^2 + C_3x^3 + C_4x^4 + C_5x^5 + ...$ where x (°) is an incidence angle of the light to the reflecting surface, a P-V (peak to valley: difference between a maximum and a minimum) value of a quantity $y' = C_2x^2 + C_3x^3 + C_4X^4 + C_5x^5 + ...$ resulting from subtraction of the first-order term $C_1x$ from the change amount y is not more than 25° in an incidence angle range of effective rays incident to the reflecting surface.

8. The optical system according to any one of claims 1 to 7, wherein a linearly polarized beam vibrating substantially in a circumferential direction in a lens aperture of the optical system is incident to the optical system.

9. The optical system according to any one of claims 1 to 8, wherein a difference between the maximum incidence angle and a minimum incidence angle of the rays incident to the reflecting surface of the reflecting mirror is not less than 20°.

10. The optical system according to any one of claims 1 to 9, said optical system having a projection optical system for forming a reduced image of an effective field region on a first surface illuminated with substantially linearly polarized light, on a second surface,
wherein the projection optical system comprises:

a first deflecting plane mirror disposed in an optical path between the first surface and the second surface;
a partial optical system disposed in an optical path between the first deflecting plane mirror and the second surface and including at least one concave reflecting mirror;
a second deflecting plane mirror disposed in an optical path between the partial optical system and the second surface;
a first lens unit disposed in an optical path between the second deflecting plane mirror and the second surface and having a positive refractive power;
an aperture stop disposed in an optical path between the first lens unit and the second surface; and
a second lens unit disposed in an optical path between the aperture stop and the second surface and having a positive refractive power;

wherein an optical path between the second surface and an optical member located nearest to the second surface out of optical members with refractive power in the projection optical system is filled with a predetermined liquid, wherein a Z-axis is set along a direction of a normal to the first surface, an X-axis along a direction perpendicular to a plane made by an entrance optical axis and an exit optical axis of the first deflecting plane mirror, and a Y-axis along a direction perpendicular to the Z-axis and to the X-axis, and
wherein a ratio of component S2 to component S0 among the Stokes parameters for rays distributed in directions at 45° and 135° relative to the X-axis in an XY plane, out of rays incident to the first surface, is not less than 0.9.

11. The optical system according to claim 10, wherein the first surface is illuminated with a linearly polarized beam vibrating substantially in a circumferential direction in the XY plane.

12. The optical system according to claim 10 or 11, further comprising a third lens unit disposed in an optical path between the first surface and the first deflecting plane mirror.

13. The optical system according to any one of claims 10 to 12, wherein, for all rays distributed in directions at 45° and 135° relative to the X-axis on an entrance pupil surface of the projection optical system, a change from a phase difference between p-polarized incident light to a reflecting surface of the first deflecting plane mirror and s-polarized incident light to the reflecting surface of the first deflecting plane mirror, to a phase difference between reflected light of the p-polarized incident light to the reflecting surface of the first deflecting plane mirror and reflected light of the s-polarized incident light to the reflecting surface of the first deflecting plane mirror is not more than 30°, and a change from a phase difference between p-polarized incident light to a reflecting surface of the second deflecting plane mirror and s-polarized incident light to the reflecting surface of the second deflecting plane mirror, to a phase difference between reflected light of the p-polarized incident light to the reflecting surface of the second deflecting plane mirror and reflected light of the s-polarized incident light to the reflecting surface of the second deflecting plane mirror is not more than 30°.

14. The optical system according to any one of claims 1 to 9, said optical system having a projection optical system comprising a first deflecting plane mirror and a second deflecting plane mirror in an order of incidence of the light and adapted to form an image of a first surface on a second surface,
wherein the first deflecting plane mirror and the second deflecting plane mirror are so arranged that a change from a phase difference between two rays before incidence to a reflecting surface of the first deflecting plane mirror, to a phase difference between the two rays after reflection on a reflecting surface of the second deflecting plane mirror is within 50° for any two rays incident to the reflecting surface of the first deflecting plane mirror.

15. The optical system according to claim 14, wherein a linearly polarized beam vibrating substantially in a circumferential direction in a lens aperture of the projection optical system is incident from the first surface to the projection optical system.

16. The optical system according to claim 14 or 15, wherein the projection optical system further comprises an optical member disposed in an optical path between the first deflecting plane mirror and the second deflecting plane mirror.

17. The optical system according to any one of claims 14 to 16, said optical system having an illumination optical system for guiding a linearly polarized beam supplied from a light source, to a surface to be illuminated,
wherein the illumination optical system comprises a third deflecting plane mirror and a fourth deflecting plane mirror in an order of incidence of the light, and
wherein the third deflecting plane mirror and the fourth deflecting plane mirror are so arranged that a change from a phase difference between two rays before incidence to a reflecting surface of the third deflecting plane mirror, to a phase difference between the two rays after reflection on a reflecting surface of the fourth deflecting plane mirror is within 50° for any two rays incident to the reflecting surface of the third deflecting plane mirror.

18. The optical system according to any one of claims 1 to 9, said optical system having an illumination optical system for guiding a linearly polarized beam supplied from a light source, to a surface to be illuminated,
wherein the illumination optical system comprises a first deflecting plane mirror and a second deflecting plane mirror in an order of incidence of the light, and
wherein the first deflecting plane mirror and the second deflecting plane mirror are so arranged that a change from a phase difference between two rays before incidence to a reflecting surface of the first deflecting plane mirror, to a phase difference between the two rays after reflection on a reflecting surface of the second deflecting plane mirror is within 50° for any two rays incident to the reflecting surface of the first deflecting plane mirror.

19. The optical system according to claim 18, wherein a linearly polarized beam vibrating substantially in a circumferential direction in a lens aperture of the illumination optical system is incident to the surface to be illuminated.

**20.** The optical system according to claim 19, said optical system comprising a circumferential polarization converting element for converting the beam supplied from the light source, into linearly polarized light vibrating substantially in a circumferential direction in a cross section of the beam.

**21.** The optical system according to any one of claims 18 to 20, wherein the illumination optical system further comprises an optical member disposed in an optical path between the first deflecting plane mirror and the second deflecting plane mirror.

**22.** An exposure apparatus comprising the optical system as defined in any one of claims 1 to 21, the exposure apparatus being adapted for exposure of a pattern lying on a mask under illumination based on a beam from a light source, on a photosensitive substrate.

**23.** The exposure apparatus according to claim 22, wherein the mask is illuminated with a linearly polarized beam vibrating substantially in a circumferential direction in the XY plane.

**24.** The exposure apparatus according to claim 22 or 23, wherein linearly polarized light being always s-polarized light for the photosensitive substrate is incident onto the photosensitive substrate.

**25.** The exposure apparatus according to claim 24, wherein a light intensity distribution eccentrically localized in a region off an optical axis is formed on an illumination pupil in an optical path between the light source and the mask.

**26.** An exposure method for effecting exposure of a pattern lying on a mask under illumination based on a beam from a light source, on a photosensitive substrate, using the optical system as defined in any one of claims 1 to 21.

**27.** The exposure method according to claim 26, wherein the mask is illuminated with a linearly polarized beam vibrating substantially in a circumferential direction in the XY plane.

**28.** The exposure method according to claim 26 or 27, wherein linearly polarized light being always s-polarized light for the photosensitive substrate is incident onto the photosensitive substrate.

**29.** The exposure method according to claim 28, wherein a light intensity distribution eccentrically localized in a region off an optical axis is formed on an illumination pupil in an optical path between the light source and the mask.

*Fig.1*

# Fig.2

10

10C

10D

10B

10E

·AX

10A

10A

10B

10D

10C

→X

↓Y

# *Fig.3*

# Fig.4

# Fig.5

# Fig.6

# *Fig.7*

# Fig.8

103
102
101

# Fig.9

*Fig.10*

104
103
102
101

*Fig.11*

*Fig.12*

*Fig.13*

# Fig.14

# Fig.15

(a)

(b)

# *Fig.16*

*Fig.17*

# Fig.18

START

↓

DEPOSIT METAL FILM ON WAFER ⟵ STEP 301

↓

APPLY PHOTORESIST ONTO THE METAL FILM ⟵ STEP 302

↓

TRANSFER IMAGE OF PATTERN ON RETICLE
INTO EACH SHOT AREA ON WAFER,
USING EXPOSURE APPARATUS OF EMBODIMENT ⟵ STEP 303

↓

PERFORM DEVELOPMENT
OF PHOTORESIST ON WAFER ⟵ STEP 304

↓

PERFORM ETCHING ON WAFER,
USING RESIST PATTERN AS MASK ⟵ STEP 305

↓

NEXT STEP

# Fig.19

```
                    ┌───────────┐
                    │   START   │
                    └─────┬─────┘
                          │
                          ▼
              ┌───────────────────────┐
              │       PATTERN         │ ────── STEP 401
              │    FORMING STEP       │
              └───────────┬───────────┘
                          │
                          ▼
          ┌───────────────────────────────┐
          │       COLOR FILTER            │ ────── STEP 402
          │      FORMING STEP             │
          └───────────────┬───────────────┘
                          │
                          ▼
          ┌───────────────────────────────┐
          │    CELL ASSEMBLING STEP       │ ────── STEP 403
          └───────────────┬───────────────┘
                          │
                          ▼
          ┌───────────────────────────────┐
          │   MODULE ASSEMBLING STEP      │ ────── STEP 404
          └───────────────┬───────────────┘
                          │
                          ▼
                    ┌───────────┐
                    │    END    │
                    └───────────┘
```

**EP 1 767 978 A1**

## INTERNATIONAL SEARCH REPORT

| International application No. |
|---|
| PCT/JP2005/010589 |

A. CLASSIFICATION OF SUBJECT MATTER
Int.Cl⁷ G02B17/08, 5/08, G03F7/20, H01L21/027

According to International Patent Classification (IPC) or to both national classification and IPC

B. FIELDS SEARCHED

Minimum documentation searched (classification system followed by classification symbols)
Int.Cl⁷ G02B17/08, 5/08, G03F7/20, H01L21/027

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2001/065296 A1 (Nikon Corp.), 07 September, 2001 (07.09.01), Page 64, lines 18 to 65, 9; all drawings | 1-6,9,14, 16-18,21,22, 24-26,28,29 |
| Y | & US 2003/11755 A1 & EP 1191378 A1 | 7,8,10-13, 15,19,20,23, 27 |
| Y | JP 11-311704 A (Nikon Corp.), 09 November, 1999 (09.11.99), Full text; all drawings & US 6310905 B1 & EP 939467 A2 | 1-6 |
| Y | JP 60-181704 A (Canon Inc.), 17 September, 1985 (17.09.85), Full text; all drawings & US 4714308 A | 1-6 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 22 August, 2005 (22.08.05) | 06 September, 2005 (06.09.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

## INTERNATIONAL SEARCH REPORT

| | International application No. |
|---|---|
| | PCT/JP2005/010589 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 5-90128 A  (Nikon Corp.),<br>09 April, 1993 (09.04.93),<br>Description; Par. Nos. [0010], [0030];<br>all drawings<br>& US 5541026 A | 8,11,15,19,<br>20,23,27 |
| A | WO 1999/49504 A1  (Nikon Corp.),<br>30 September, 1999 (30.09.99),<br>Full text; all drawings<br>& AU 2747999 A | 10-13 |
| A | JP 10-303114 A  (Nikon Corp.),<br>13 November, 1998 (13.11.98),<br>Full text; all drawings<br>(Family: none) | 10-13 |
| A | JP 6-124873 A  (Canon Inc.),<br>06 May, 1994 (06.05.94),<br>Full text; all drawings<br>(Family: none) | 10-13 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5090128 A
- WO 9949504 A
- JP 10303114 A
- WO 2005036619 A
- JP 2004016247 W
- US 2004012764 A
- JP 6124873 A